# EUROPEAN PATENT SPECIFICATION

(11) **EP 3 113 369 B1**
(45) Date of publication and mention of the grant of the patent: **04.09.2019**
(21) Application number: 16177525.9
(22) Date of filing: 01.07.2016
(51) Int. Cl.: H04B 1/00, H04B 1/18, H03J 5/24, H01Q 1/24, H04B 1/16

(54) **ELECTRONIC DEVICE WITH PARALLEL RECEIVING FILTERING MODULES AND RECEIVING METHOD THEREOF**
ELEKTRONISCHE VORRICHTUNG MIT PARALLELEN EMPFANGSFILTERMODULEN UND EMPFANGSVERFAHREN DAFÜR
DISPOSITIF ÉLECTRONIQUE AVEC MODULES RÉCEPTION DE FILTRATION PARALLÈLES ET PROCÉDÉ DE RÉCEPTION ASSOCIÉ

(30) Priority: 03.07.2015 KR 20150095478
(43) Date of publication of application: 04.01.2017
(73) Proprietor: Samsung Electronics Co., Ltd., Gyeonggi-do 16677 (KR); Wisol Co., Ltd., Gyeonggi-do (KR)
(72) Inventor: YANG, Dongil, Gyeonggi-do (KR); SIM, Sang-Hun, Gyeonggi-do (KR); LEE, Jae-Hoon, Gyeonggi-do (KR); HWANG, Kyu-Han, Gyeonggi-do (KR)
(74) Representative: HGF Limited

(56) References cited:
- US-A- 5 640 694
- US-A1- 2008 214 137
- US-A1- 2014 361 839

## Description

### TECHNICAL FIELD

The present disclosure relates to an electronic device and an operating method thereof. More particularly, the present disclosure relates to an electronic device capable of wireless communication and a receiving method thereof.

### BACKGROUND

Recently, with the evolution of communication technologies, a multitude of frequency bands available for wireless communication have been established. An electronic device may communicate in various communication schemes through the multiple frequency bands. The electronic device may be provided with a plurality of components in order to support communication schemes. For example, the components may include an antenna, a switch, a band-pass filter, and the like.

The electronic device may be implemented in different structures according to the supported communication scheme. That is, the arrangement and connection of the components may vary according to the communication scheme supported by the electronic device. Accordingly, the electronic device may need to secure a space required for the arrangement of the components. In addition, in the electronic device as described above, a manufacturing cost may be increased according to the price of the components.

An electronic device and a receiving method thereof according to an embodiment of the present disclosure may support various communication schemes. An electronic device and a receiving method thereof according to an embodiment of the present disclosure may reduce the manufacturing cost.
US patent application number 2008/0214137 A1 (Qian) describes an RF filtering and amplifying apparatus comprising a plurality of RF filters connected with each other in a manner of cascade for filtering a received radio signal level by level.
US patent application number 2014/0361839 A1 (Scott et al) describes an apparatus including a first electronic device, a first nonlinear capacitance compensation circuit and a capacitance compensation control circuit. The capacitance compensation control circuit adjusts the first compensation capacitance using the first compensation control signal to at least partially linearize the first nonlinear capacitance.
US patent number 5,640,694 (Milton, Jr.) describes an integrated RF avionics system with a common IF interface for diverse functions such as radar, electronic waveform and communications/navigation/identification (CNI). The interface uses a segmented band of IF frequencies which are subdivided into two or more individual band segments separated by a guard band segment.

### SUMMARY

Aspects of the present disclosure are to address at least the above-mentioned problems and/or disadvantages and to provide at least the advantages described below. Accordingly, an aspect of the present disclosure is to provide an electronic device and an operating method thereof.

In accordance with an aspect of the present disclosure, an electronic device is provided. The electronic device may include at least one antenna, at least one filtering module configured to filter a wireless signal received from the antenna and a wireless processor. The filtering module may comprise a first filter unit comprising a first plurality of filters configured to pass different frequency bands which are adjacent to each other, and an amplifier configured to amplify the wireless signal which has passed through the first filter unit. The electronic device further comprising a second filter unit which is connected to the at least one filtering module, the second filter unit being configured to receive the amplified wireless signal from the at least one filtering module and pass a predetermined frequency band in the received wireless signal. The plurality of filters are configured to share one output terminal, and each of the plurality of filters is configured to connect to the amplifier through the one output terminal. The second filter unit comprises a second plurality of filters and a plurality of output terminals, an output terminal being individually connected to each of the second plurality of filters, and each output terminal being individually connected to the wireless processor.

In accordance with another aspect of the present disclosure, a method of an electronic device having at least one antenna and a wireless processor is provided. The method may include connecting at least one filtering module to the antenna, filtering, by a first filter unit of the filtering module, a wireless signal received from the antenna, amplifying, by an amplifier connected to the first filter unit, the wireless signal which has passed through the first filter unit, and filtering, by a second filter unit connected to the amplifier, the amplified wireless signals. The filtering module comprises the first filter unit comprising a plurality of filters configured to pass different frequency bands which are adjacent to each other, and the amplifier configured to amplify the wireless signal which has passed through the filter unit, wherein the plurality of filters are configured to share one output terminal, and each of the plurality of filters are configured to connect the amplifier through the one output terminal. The second filter unit comprises a second plurality of filters and a plurality of output terminals, an output terminal being individually connected to each of the second plurality of filters, and each output terminal being individually connected to the wireless processor.

An electronic device and a receiving method thereof according to an embodiment of the present disclosure may support various communication schemes by using a filtering module. At this time, one filtering module is provided with a plurality of band-pass filters, and frequency bands of the band-pass filters may be adjacent to each other. Accordingly, the electronic device may perform carrier aggregation (CA) even for carriers which have a relatively narrow frequency interval.

An electronic device and a receiving method thereof according to an embodiment of the present disclosure may be implemented in various structures by using a filtering module. In other words, regardless of whether CA is performed in the electronic device, the filtering module can be applied to various structures of the electronic device. At this time, since the filtering module includes a plurality of filters, a space for the arrangement of the filters can be reduced in the electronic device. In addition, manufacturing cost for the electronic device can be reduced.

Other aspects, advantages, and salient features of the disclosure will become apparent to those skilled in the art from the following detailed description, which, taken in conjunction with the annexed drawings, discloses various embodiments of the present disclosure.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 illustrates a network environment system according to various embodiments of the present disclosure;
FIG. 2 is a block diagram of an electronic device according to various embodiments of the present disclosure;
FIG. 3 is a block diagram of a programming module according to various embodiments of the present disclosure;
FIG. 4 is a block diagram of an electronic device according to various embodiments of the present disclosure;
FIG. 5 is a block diagram of a communication unit in FIG. 4 according to an embodiment of the present disclosure;
FIG. 6 is a block diagram of an antenna connection unit in an electronic device according to technology of related art;
FIG. 7 is a block diagram of an antenna connection unit in an electronic device according to a first embodiment of the present disclosure;
FIG. 8 is a block diagram of an antenna connection unit in an electronic device according to a second embodiment of the present disclosure;
FIG. 9 is a block diagram of an antenna connection unit in an electronic device according to a third embodiment of the present disclosure; and
FIG. 10 is a flow chart of a receiving method of an electronic device according to various embodiments of the present disclosure.

Throughout the drawings, like reference numerals will be understood to refer to like parts, components, and structures.

### DETAILED DESCRIPTION

The following description with reference to the accompanying drawings is provided to assist in a comprehensive understanding of various embodiments of the present disclosure as defined by the claims. It includes various specific details to assist in that understanding but these are to be regarded as merely exemplary. Accordingly, those of ordinary skill in the art will recognize that various changes and modifications of the various embodiments described herein can be made without departing from the scope of the present disclosure. In addition, descriptions of well-known functions and constructions may be omitted for clarity and conciseness.

The terms and words used in the following description and claims are not limited to the bibliographical meanings, but, are merely used by the inventor to enable a clear and consistent understanding of the present disclosure. Accordingly, it should be apparent to those skilled in the art that the following description of various embodiments of the present disclosure is provided for illustration purpose only and not for the purpose of limiting the present disclosure as defined by the appended claims.

It is to be understood that the singular forms "a," "an," and "the" include plural referents unless the context clearly dictates otherwise. Thus, for example, reference to "a component surface" includes reference to one or more of such surfaces.

In the present disclosure, the expression "A or B", "at least one of A and/or B", or "A/B" may include all possible combinations of the items listed. The expression "a first", "a second", "the first", or "the second" may modify corresponding elements regardless of the order or importance, and is used only to distinguish one element from another element, but does not limit the corresponding
elements. When an element (e.g., first element) is referred to as being "(functionally or communicatively) connected," or "directly coupled" to another element (second element), the element may be connected directly to the another element or connected to the another element through yet another element (e.g., third element).

The expression "configured to" as used in various embodiments of the present disclosure may be interchangeably used with, for example, "suitable for", "having the capacity to", "designed to", "adapted to", "made to", or "capable of" in terms of hardware or software, according to circumstances. Alternatively, in some situations, the expression "device configured to" may mean that the device, together with other devices or components, "is able to". For example, the phrase "processor adapted (or configured) to perform A, B, and C" may mean a dedicated processor (e.g. embedded processor) only for performing the corresponding operations or a generic-purpose processor (e.g., central processing unit (CPU) or application processor (AP)) that can perform the corresponding operations by executing one or more software programs stored in a memory device.

An electronic device according to various embodiments of the present disclosure may include at least one of, for example, a smart phone, a tablet personal computer (PC), a mobile phone, a video phone, an electronic book reader (e-book reader), a desktop PC, a laptop PC, a netbook computer, a workstation, a server, a personal digital assistant (PDA), a portable multimedia player (PMP), a Moving Picture Experts Group phase 1 or phase 2 (MPEG-1 or MPEG-2) audio layer-3 (MP3) player, a mobile medical device, a camera, and a wearable device. According to various embodiments, the wearable device may include at least one of an accessory type (e.g., a watch, a ring, a bracelet, an anklet, a necklace, a glasses, a contact lens, or a head-mounted device (HMD)), a fabric or clothing integrated type (e.g., an electronic clothing), a body-mounted type (e.g., a skin pad, or tattoo), and a bio-implantable type (e.g., an implantable circuit). In some embodiments, the electronic device may include at least one of, for example, a television (TV), a digital versatile disc (DVD) player, an audio, a refrigerator, an air conditioner, a vacuum cleaner, an oven, a microwave oven, a washing machine, an air cleaner, a set-top box, a home automation control panel, a security control panel, a TV box (e.g., Samsung HomeSync™, Apple TV™, or Google TV™), a game console (e.g., Xbox™ and PlayStation™), an electronic dictionary, an electronic key, a camcorder, and an electronic photo frame.

In other embodiments, the electronic device may include at least one of various medical devices (e.g., various portable medical measuring devices (a blood glucose monitoring device, a heart rate monitoring device, a blood pressure measuring device, a body temperature measuring device, etc.), a magnetic resonance angiography (MRA), a magnetic resonance imaging (MRI), a computed tomography (CT) machine, and an ultrasonic machine), a navigation device, a global positioning system (GPS) receiver, an event data recorder (EDR), a flight data recorder (FDR), a vehicle infotainment devices, an electronic devices for a ship (e.g., a navigation device for a ship, and a gyro-compass), avionics, security devices, an automotive head unit, a robot for home or industry, an automatic teller's machine (ATM) in banks, point of sales (POS) in a shop, or internet device of things (e.g., a light bulb, various sensors, electric or gas meter, a sprinkler device, a fire alarm, a thermostat, a streetlamp, a toaster, a sporting goods, a hot water tank, a heater, a boiler, etc.). According to some embodiments, an electronic device may include at least one of a part of furniture or a building/structure, an electronic board, an electronic signature receiving device, a projector, and various types of measuring instruments (e.g., a water meter, an electric meter, a gas meter, a radio wave meter, and the like). In various embodiments, the electronic device may be flexible, or may be a combination of one or more of the aforementioned various devices. The electronic device according to one embodiment of the present disclosure is not limited to the above described devices. In the present disclosure, the term "user" may indicate a person using an electronic device or a device (e.g., an artificial intelligence electronic device) using an electronic device.

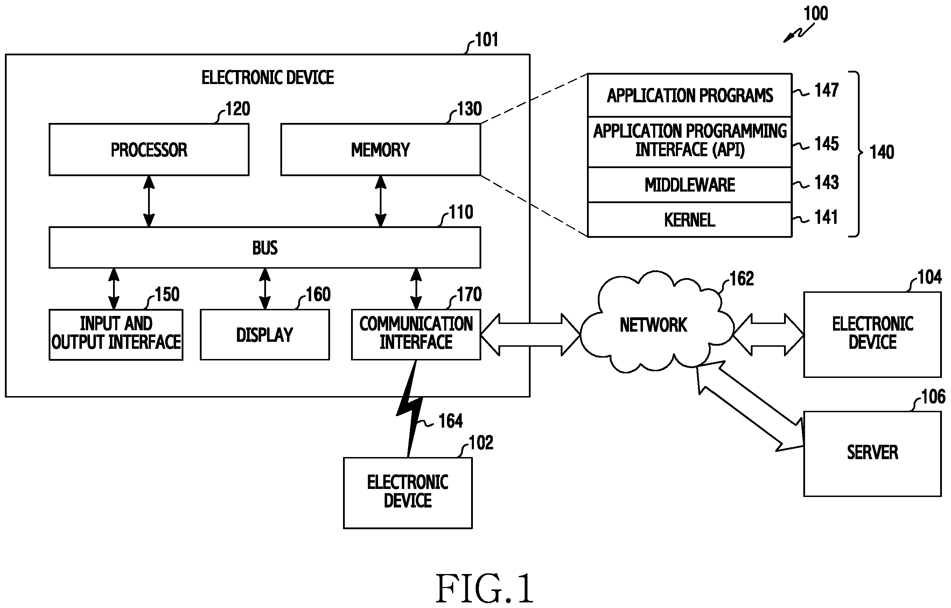

FIG. 1 illustrates a network environment system according to various embodiments of the present disclosure.

Referring to FIG. 1, an electronic device 101 within a network environment 100, according to various embodiments, will be described. The electronic device 101 may include a bus 110, a processor 120, a memory 130, an input/output interface 150, a display 160, and a communication circuit or interface 170. In some embodiments, the electronic device 101 may omit at least one of the elements, or may further include other elements. The bus 110 may include, for example, a circuit that interconnects the elements 110 to 170 and transfers communication (e.g., control messages and/or data) between the elements. The processor 120 may include one or more CPUs, an AP, and a communication processor (CP). For example, the processor 120 may carry out operations or data processing relating to the control and/or communication of at least one other element of the electronic device 101.

The memory 130 may include a volatile memory and/or a non-volatile memory. The memory 130 may store, for example, instructions or data relating to at least one other element of the electronic device 101. According to an embodiment, the memory 130 may store software and/or a program 140. The program 140 may include, for example, a kernel 141, middleware 143, an application programming interface (API) 145, and/or application programs (or "applications") 147. At least a part of the kernel 141, the middleware 143, or the API 145 may be referred to as an operating system (OS). For example, the kernel 141 may control or manage system resources (e.g., the bus 110, the processor 120, the memory 130, etc.) that are used to execute operations or functions implemented in the other programs (e.g., the middleware 143, the API 145, and the application programs 147). Furthermore, the kernel 141 may provide an interface through which the middleware 143, the API 145, or the application programs 147 may access the individual elements of the electronic device 101 to control or manage the system resources.

The middleware 143 may function, for example, as an intermediary for allowing the API 145 or the application programs 147 to communicate with the kernel 141 to exchange data. In addition, the middleware 143 may process one or more task requests received from the application programs 147 according to priorities thereof. For example, the middleware 143 may assign priorities for using the system resources (e.g., the bus 110, the processor 120, the memory 130, etc.) of the electronic device 101 to one or more of the application programs 147, and may process the one or more task requests. The API 145 is an interface used by the applications 147 to control a function provided from the kernel 141 or the middleware 143, and may include, for example, at least one interface or function (e.g., instruction) for file control, window control, image processing, text control, etc. For example, the input/output interface 150 may forward instructions or data, which is input from a user or an external device, to the other element(s) of the electronic device 101, or may output instructions or data, which is received from the other element(s) of the electronic device 101, to the user or the external device.

The display 160 may include, for example, a liquid crystal display (LCD), a light emitting diode (LED) display, an organic LED (OLED) display, a micro electro mechanical system (MEMS) display, or an electronic paper display. The display 160 may display, for example, various types of content (e.g., text, images, videos, icons, and/or symbols) for a user. The display 160 may include a touch screen and may receive, for example, a touch input, a gesture input, a proximity input, or a hovering input using an electronic pen or a user's body part. The communication interface 170 may configure, for example, communication between the electronic device 101 and an external device (e.g., a first external electronic device 102, a second external electronic device 104, or a server 106). For example, the communication interface 170 may be connected to a network 162 through wireless or wired communication to communicate with the external device (e.g., the second external device 104 or the server 106). In another example, the communication interface 170 may be in communication, via a wireless connection 164, with the first external electronic device 102, as illustrated in FIG. 1.

The wireless communication may include, for example, a cellular communication that uses at least one of long term evolution (LTE), LTE-advanced (LTE-A), code division multiple access (CDMA), wideband CDMA (WCDMA), universal mobile telecommunications system (UMTS), wireless broadband (WiBro), global system for mobile communications (GSM), etc. According to an embodiment, the wireless communication may include, for example, at least one of Wi-Fi, Bluetooth, Bluetooth low energy (BLE), ZigBee, near field communication (NFC), magnetic secure transmission, radio frequency, and body area network (BAN). According to an embodiment, the wired communication may include global navigation satellite system (GNSS). The GNSS may be, for example, a GPS, a global navigation satellite system (GLONASS), a BeiDou navigation satellite system (hereinafter, referred to as "BeiDou"), or Galileo (the European global satellite-based navigation system). Hereinafter, the term "GPS" may be interchangeably used with the term "GNSS" in the present disclosure. The wired communication may include, for example, at least one of a universal serial bus (USB), a high definition multimedia interface (HDMI), recommended standard 232 (RS-232), and a plain old telephone service (POTS). The network 162 may include a telecommunications network, which may be, for example, at least one of a computer network (e.g., a local area network (LAN) or a wide area network (WAN)), the Internet, and a telephone network.

The first and second external electronic devices 102 and 104 may be the same type as, or a different type than, the electronic device 101. According to various embodiments, all or some of the operations performed in the electronic device 101 may be performed in another electronic device or in a plurality of electronic devices (e.g., the electronic devices 102 and 104 or the server 106). According to an embodiment, in a case where the electronic device 101 has to perform some functions or services automatically or in response to a request, the electronic device 101 may request another device (e.g., the electronic device 102 or 104 or the server 106) to perform at least some functions relating thereto instead of, or in addition to, performing the functions or services by itself. The other electronic device (e.g., the electronic device 102 or 104, or the server 106) may execute the requested functions or the additional functions and may deliver the execution result to the electronic device 101. The electronic device 101 may process the received result as it is or additionally to provide the requested functions or services. To achieve this, for example, cloud computing, distributed computing, or client-server computing technology may be used.

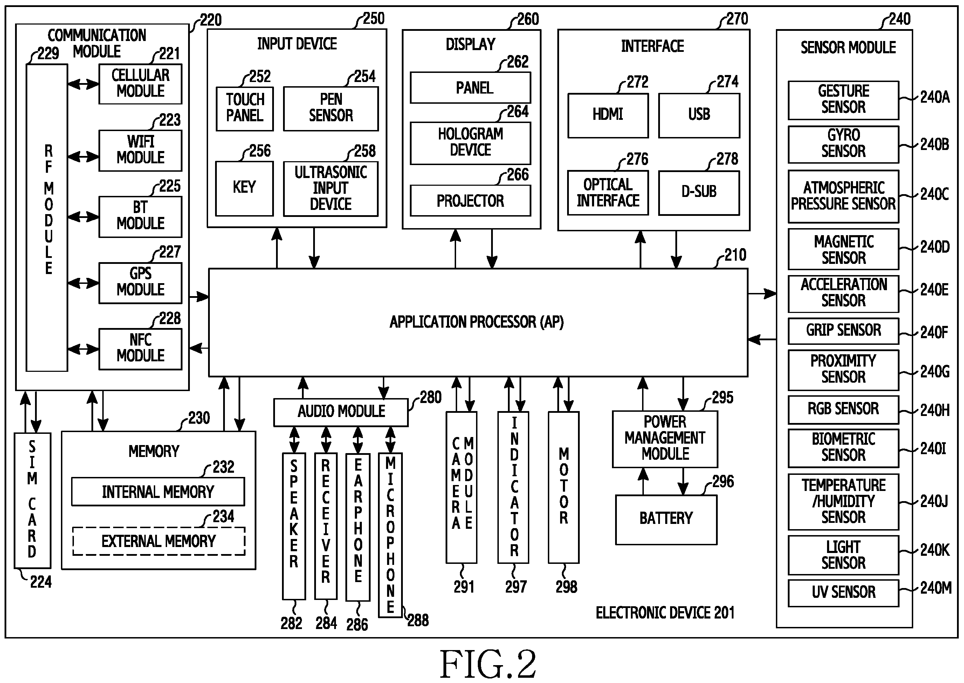

FIG. 2 is a block diagram of an electronic device 201 according to various embodiments of the present disclosure.

Referring to FIG. 2, the electronic device 201 may include, for example, the entirety, or a part, of the electronic device 101 illustrated in FIG. 1. The electronic device 201 may include at least one processor 210 (e.g., an AP), a communication module 220, a subscriber identification module (SIM) 224, a memory 230, a sensor module 240, an input device 250, a display 260, an interface 270, an audio module 280, a camera module 291, a power management module 295, a battery 296, an indicator 297, and a motor 298. The processor 210 may, for example, control a plurality of hardware or software elements connected thereto and perform various types of data processing and operations by driving an operating system or an application program. The processor 210 may be implemented as, for example, a system on chip (SoC). According to an embodiment, the processor 210 may further include a graphics processing unit (GPU) and/or an image signal processor. The processor 210 may include at least some (e.g., a cellular module 221) of the elements illustrated in FIG. 2. The processor 210 may load, in a volatile memory, instructions or data received from at least one of the other elements (e.g., a non-volatile memory), process the loaded instructions or data, and store the result data in the non-volatile memory.

The communication module 220 may have a configuration that is the same as, or similar to, that of the communication interface 170. The communication module 220 may include, for example, a cellular module 221, a Wi-Fi module 223, a Bluetooth module 225, a GNSS or GPS module 227, an NFC module 228, and a radio frequency (RF) module 229. The cellular module 221 may provide, for example, a voice call, a video call, a text message service, an internet service, etc. through a communication network. According to an embodiment, the cellular module 221 may identify and authenticate the electronic device 201 within a communication network using the SIM 224 (e.g., a SIM card). According to an embodiment, the cellular module 221 may perform at least some of the functions that the processor 210 may provide. According to an embodiment, the cellular module 221 may include a CP. According to some embodiments, at least some (two or more) of the cellular module 221, the Wi-Fi module 223, the Bluetooth module 225, the GNSS module 227, and the NFC module 228 may be included in one integrated chip (IC) or IC package. The RF module 229 may transmit/receive, for example, a communication signal (e.g., an RF signal). The RF module 229 may include, for example, a transceiver, a power amp module (PAM), a frequency filter, a low noise amplifier (LNA), an antenna, etc. According to an embodiment, at least one of the cellular module 221, the Wi-Fi module 223, the Bluetooth module 225, the GNSS module 227, and the NFC module 228 may transmit/receive an RF signal through a separate RF module. The SIM 224 may include, for example, a card that includes a SIM, or an embedded SIM, and may contain unique identification information (e.g., an integrated circuit card identifier (ICCID)) or subscriber information (e.g., international mobile subscriber identity (IMSI)).

The memory 230 (e.g., the memory 130) may include, for example, an internal memory 232 or an external memory 234. The internal memory 232 may include, for example, at least one of a volatile memory (e.g., a dynamic random access memory (DRAM), a static random access memory (SRAM), a synchronous DRAM (SDRAM), etc.) and a non-volatile memory (e.g., a one time programmable read only memory (OTPROM), a PROM, an erasable PROM (EPROM), an electrically erasable PROM (EEPROM), a mask ROM, a flash ROM, a flash memory, a hard disk drive, or a solid state drive (SSD)). The external memory 234 may include a flash drive, for example, a compact flash (CF), a secure digital (SD), a micro-SD, a mini-SD, an extreme digital (xD), a multi-media card (MMC), a memory stick, etc. The external memory 234 may be functionally or physically connected to the electronic device 201 through various interfaces.

The sensor module 240 may, for example, measure a physical quantity or detect the operating state of the electronic device 201 and may convert the measured or detected information into an electrical signal. The sensor module 240 may include, for example, at least one of a gesture sensor 240A, a gyro sensor 240B, an atmospheric pressure sensor 240C, a magnetic sensor 240D, an acceleration sensor 240E, a grip sensor 240F, a proximity sensor 240G, a color or RGB sensor 240H (e.g., a red, green, blue (RGB) sensor), a biometric sensor 240I, a temperature/humidity sensor 240J, an illumination sensor 240K, and an ultraviolet (UV) sensor 240M. Additionally or alternatively, the sensor module 240 may include, for example, an e-nose sensor, an electromyography (EMG) sensor, an electroencephalogram (EEG) sensor, an electrocardiogram (ECG) sensor, an infrared (IR) sensor, an iris sensor, and/or a fingerprint sensor. The sensor module 240 may further include a control circuit for controlling one or more sensors included therein. In some embodiments, the electronic device 201 may further include a processor configured to control the sensor module 240 as a part of, or separately from, the processor 210 and may control the sensor module 240 while the processor 210 is in a sleep state.

The input device 250 may include, for example, a touch panel 252, a (digital) pen sensor 254, a key 256, or an ultrasonic input device 258. The touch panel 252 may use, for example, at least one of a capacitive type, a resistive type, an infrared type, and an ultrasonic type. Furthermore, the touch panel 252 may further include a control circuit. The touch panel 252 may further include a tactile layer to provide a tactile reaction to a user. The (digital) pen sensor 254 may include, for example, a recognition sheet that is a part of, or separate from, the touch panel. The key 256 may include, for example, a physical button, an optical key, or a keypad. The ultrasonic input device 258 may detect ultrasonic waves, which are generated by an input tool, through a microphone (e.g., a microphone 288) to identify data that correspond to the detected ultrasonic waves.

The display 260 (e.g., the display 160) may include a panel 262, a hologram device 264, a projector 266, and/or a control circuit for controlling them. The panel 262 may be implemented to be, for example, flexible, transparent, or wearable. The panel 262, together with the touch panel 252, may be configured as one or more modules. The hologram device 264 may show a three-dimensional image in the air using an interference of light. The projector 266 may display an image by projecting light onto a screen. The screen may be located, for example, inside or outside the electronic device 201. The interface 270 may include, for example, an HDMI 272, a USB 274, an optical interface 276, or a D-subminiature (D-sub) 278. The interface 270 may be included, for example, in the communication interface 170 illustrated in FIG. 1. Additionally or alternatively, the interface 270 may include, for example, a mobile high-definition link (MHL) interface, an SD card/ MMC interface, or an infrared data association (IrDA) standard interface.

The audio module 280, for example, may convert a sound into an electrical signal, and vice versa. At least some elements of the audio module 280 may be included, for example, in the input/output interface 150 illustrated in FIG. 1. The audio module 280 may process sound information that is input or output through, for example, a speaker 282, a receiver 284, earphones 286, the microphone 288, etc. The camera module 291 is a device that can photograph a still image and a moving image. According to an embodiment, the camera module 291 may include one or more image sensors (e.g., a front sensor or a rear sensor), a lens, an image signal processor (ISP), or a flash (e.g., an LED or xenon lamp). The power management module 295 may manage, for example, the power of the electronic device 201. According to an embodiment, the power management module 295 may include a power management IC (PMIC), a charger IC, or a battery or fuel gauge. The PMIC may have a wired and/or wireless charging scheme. Examples of the wireless charging scheme may include a magnetic resonance method, a magnetic induction method, an electromagnetic wave method, etc. Additional circuits (e.g., a coil loop, a resonance circuit, a rectifier, etc.) for wireless charging may be further included. The battery gauge may measure, for example, the residual quantity of the battery 296 and a voltage, current, or temperature while charging. The battery 296 may include, for example, a rechargeable battery and/or a solar battery.

The indicator 297 may display a particular state (e.g., a booting state, a message state, a charging state, etc.) of the electronic device 201 or a part thereof (e.g., the processor 210). The motor 298 may convert an electrical signal into a mechanical vibration and may generate a vibration, a haptic effect, etc. The electronic device 201 may include a mobile TV support device that can process media data according to a standard, such as digital multimedia broadcasting (DMB), digital video broadcasting (DVB), mediaFlo™, etc. Each of the above-described component elements of hardware according to the present disclosure may be configured with one or more components, and the names of the corresponding component elements may vary based on the type of electronic device. In various embodiments, an electronic device (e.g., the electronic device 201) may omit some elements or may further include additional elements, or some of the elements of the electronic device may be combined with each other to configure one entity, in which case the electronic device may identically perform the functions of the corresponding elements prior to the combination.

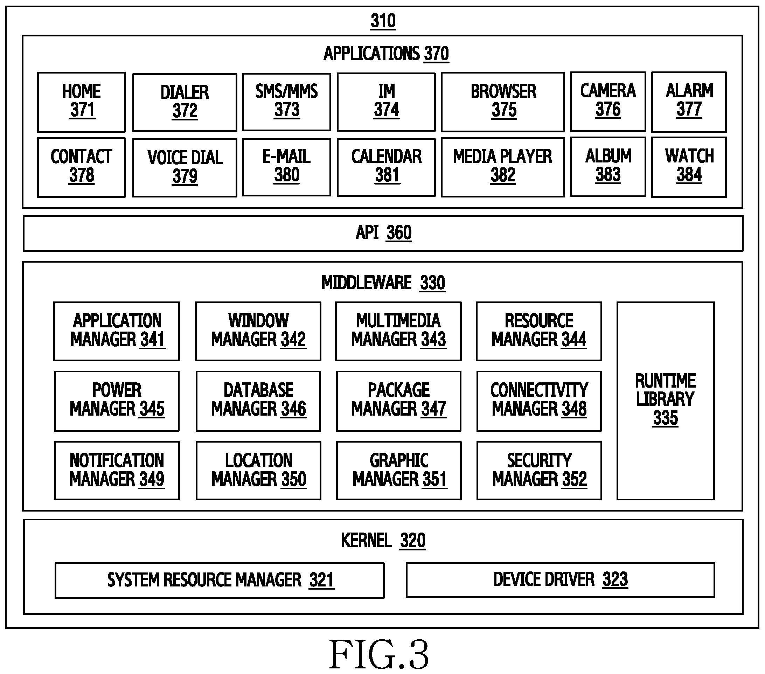

FIG. 3 is a block diagram of a program module according to various embodiments of the present disclosure. According to an embodiment, the program module 310 (e.g., the program 140) may include an OS that controls resources relating to an electronic device (e.g., the electronic device 101) and/or various applications (e.g., the application programs 147) that are driven on the operating system. The operating system may include, for example, Android™, iOS™, Windows™, Symbian™, Tizen™, or Bada™.

Referring to FIG. 3, the program module 310 may include a kernel 320 (e.g., the kernel 141), middleware 330 (e.g., the middleware 143), an API 360 (e.g., the API 145), and/or applications 370 (e.g., the application programs 147). At least a part of the program module 310 may be preloaded on the electronic device, or may be downloaded from an external electronic device (e.g., the electronic device 102 or 104 or the server 106).

The kernel 320 may include, for example, a system resource manager 321 and/or a device driver 323. The system resource manager 321 may control, allocate, or retrieve system resources. According to an embodiment, the system resource manager 321 may include a process manager, a memory manager, or a file system manager. The device driver 323 may include, for example, a display driver, a camera driver, a Bluetooth driver, a shared memory driver, a USB driver, a keypad driver, a Wi-Fi driver, an audio driver, or an inter-process communication (IPC) driver. For example, the middleware 330 may provide a function required by the applications 370 in common, or may provide various functions to the applications 370 through the API 360 to enable the applications 370 to use the limited system resources within the electronic device. According to an embodiment, the middleware 330 may include at least one of a runtime library 335, an application manager 341, a window manager 342, a multi-media manager 343, a resource manager 344, a power manager 345, a database manager 346, a package manager 347, a connectivity manager 348, a notification manager 349, a location manager 350, a graphic manager 351, and a security manager 352.

The runtime library 335 may include, for example, a library module used by a compiler in order to add a new function through a programming language while the applications 370 are being executed. The runtime library 335 may manage an input/output, manage a memory, or process an arithmetic function. The application manager 341 may manage, for example, the life cycles of the applications 370. The window manager 342 may manage graphical user interface (GUI) resources used for a screen. The multimedia manager 343 may identify formats required for reproducing various media files and may encode or decode a media file using a codec suitable for the corresponding format. The resource manager 344 may manage the source codes of the applications 370 or the space of a memory. The power manager 345 may manage, for example, the capacity or power of a battery and may provide power information required for operating the electronic device. According to an embodiment, the power manager 345 may operate in conjunction with a basic input/output system (BIOS). The database manager 346 may, for example, generate, search, or change databases to be used by the applications 370. The package manager 347 may manage the installation or update of an application that is distributed in the form of a package file.

The connectivity manager 348 may manage, for example, wireless connection. The notification manager 349 may provide an event (e.g., an arrival message, an appointment, a proximity notification, etc.) to a user. The location manager 350 may manage, for example, the location information of the electronic device. The graphic manager 351 may manage, for example, a graphic effect to be provided to a user, or a user interface relating thereto. The security manage 352 may provide, for example, system security or user authentication. According to an embodiment, the middleware 330 may include a telephony manager for managing a voice or video call function of the electronic device or a middleware module that is capable of forming a combination of the functions of the above-described elements. According to an embodiment, the middleware 330 may provide specialized modules according to the types of operation systems. The middleware 330 may dynamically remove some of the existing elements, or may add new elements. The API 360 is, for example, a set of API programming functions, and may be provided with different configurations according to operating systems. For example, in the case of Android or iOS, each platform may be provided with one API set, and in the case of Tizen, each platform may be provided with two or more API sets.

The applications 370 may include, for example, one or more applications that can perform functions, such as home 371, dialer 372, short message service (SMS)/multimedia message service (MMS) 373, instant message (IM) 374, browser 375, camera 376, alarm 377, contacts 378, voice dial 379, e-mail 380, calendar 381, media player 382, album 383, watch 384, health care (e.g., measuring exercise quantity or blood glucose), providing of environment information (e.g., atmospheric pressure, humidity, or temperature information), and the like. According to an embodiment, the applications 370 may include an information exchange application that can support the exchange of information between the electronic device and an external electronic device. The information exchange application may include, for example, a notification relay application for relaying particular information to an external electronic device or a device management application for managing an external electronic device. For example, the notification relay application may relay notification information generated in the other applications of the electronic device to an external electronic device, or may receive notification information from an external electronic device to provide the received notification information to a user. The device management application may install, delete, or update functions of an external electronic device that communicates with the electronic device (e.g., turning on/off the external electronic device itself (or some elements thereof) or adjusting the brightness (or resolution) of a display) or applications executed in the external electronic device. According to an embodiment, the applications 370 may include applications (e.g., a health care application of a mobile medical appliance) that are designated according to the attributes of an external electronic device. According to an embodiment, the applications 370 may include applications received from an external electronic device. At least some of the program module 310 may be implemented in software, firmware, hardware (e.g., the processor 210), or a combination of two or more thereof. At least some of the program module 310 may include, for example, a module, a program, a routine, a set of instructions, and/or a process for performing one or more functions.

The term "module" as used herein includes a unit that includes hardware, software, or firmware and may be used interchangeably with the term, for example, "logic", "logical block, or "circuit. The "module" may be an integrated part, or a minimum unit for performing one or more functions or a part thereof. The "module" may be mechanically or electronically implemented and may include, for example, an application-specific IC (ASIC) chip, a field-programmable gate array (FPGA), or a programmable-logic device, which has been known or are to be developed in the future, for performing certain operations. At least some of devices (e.g., modules or functions thereof) or methods (e.g., operations) according to various embodiments may be implemented by an instruction which is stored a computer-readable storage medium (e.g., the memory 130) in the form of a program module. The instruction, when executed by a processor (e.g., the processor 120), may cause the one or more processors to execute the function corresponding to the instruction. The computer-readable storage medium may include a hard disk, a floppy disk, a magnetic medium (e.g., a magnetic tape), an optical media (e.g., compact disc ROM (CD-ROM), DVD), a magneto-optical media (e.g., a floptical disk), an inner memory, etc. The instruction may include a code which is made by a compiler or a code which may be executed by an interpreter. The programming module according to the present disclosure may include one or more of the aforementioned components or may further include other additional components, or some of the aforementioned components may be omitted. Operations performed by a module, a programming module, or other elements according to various embodiments may be executed sequentially, in parallel, repeatedly, or in a heuristic manner. At least some operations may be executed according to another sequence, may be omitted, or may further include other operations.

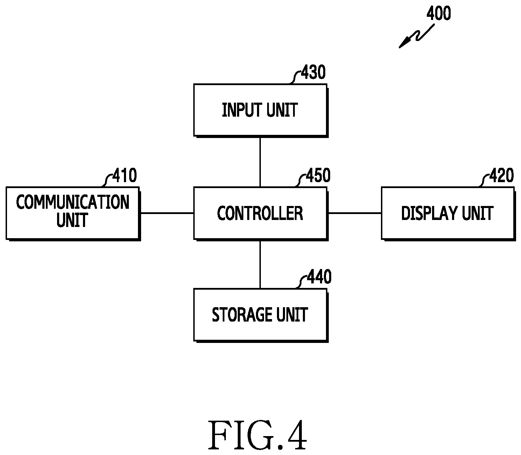

FIG. 4 is a block diagram of an electronic device according to various embodiments of the present disclosure.

Referring to FIG. 4, the communication unit 410 may perform communication in the electronic device 400. The communication unit 410 may communicate with an external device (not shown) in various communication schemes. The communication unit 410 may perform at least one of wireless communication and wired communication. For example, the external device may include an electronic device, a base station, a server, and a satellite. To this end, the communication unit 410 may access at least one of a mobile communication network, a data communication network, and a short-range communication network. For example, communication schemes may include LTE, WCDMA, GSM, Wi-Fi, Bluetooth, and NFC.

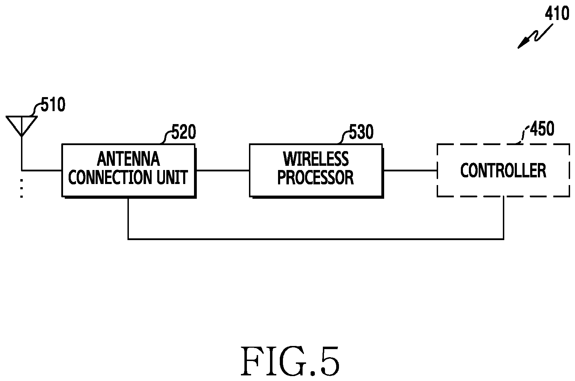

FIG. 5 is a block diagram of a communication unit in FIG. 4 according to an embodiment of the present disclosure.

Referring to FIG. 5, the communication unit 410 may include at least one antenna 510, an antenna connection unit 520, and a wireless processor 530.

The antenna 510 may receive a wireless signal from the air. The antenna 510 may receive an electromagnetic wave as a wireless signal. The antenna 510 may receive a wireless signal at a pre-determined frequency band. The antenna 510 may receive a wireless signal at a frequency band of the supported communication scheme. The antenna 510 may transmit a wireless signal to the antenna connection unit 520.

The antenna connection unit 520 may pre-process the wireless signal. The antenna connection unit 520 may receive the wireless signal from the antenna 510. The antenna connection unit 520 may separate a predetermined frequency band from the wireless signal. The antenna connection unit 520 may transmit the wireless signal to the wireless processor 530.

The wireless processor 530 may process the wireless signal into an electrical signal. The wireless processor 530 may receive the wireless signal from the antenna connection unit 520. The wireless processor 530 may convert the wireless signal into an electrical signal. For example, the wireless processor 530 may include at least one of a transceiver, a receiver, an amplifier, or a mixer.

On the other hand, the wireless processor 530 may process the electrical signal into a wireless signal. The wireless processor 530 may transmit the wireless signal to the antenna connection unit 520. The wireless processor 530 may convert the electrical signal into a wireless signal. For example, the wireless processor 530 may include at least one of a transceiver, an amplifier, or a mixer.

The antenna connection unit 520 may pre-process the wireless signal. The wireless connection unit 520 may receive the wireless signal from the wireless processor 530. The antenna connection unit 520 may amplify the wireless signal. The antenna connection unit 520 may transmit the wireless signal to the antenna 510.

The antenna 510 may transmit the wireless signal to the air. The antenna 510 may receive the wireless signal from the antenna connection unit 520 and transmit the wireless signal into the air. The antenna 510 may radiate the wireless signal to an electromagnetic wave. The antenna 510 may transmit the wireless signal at a pre-determined frequency band. The antenna 510 may transmit the wireless signal at a frequency band of the supported communication scheme.

With reference to FIGS. 4 and 5, the display unit 420 may output display data from the electronic device 400. For example, the display unit 420 may include an LCD, an LED display, an OLED display, an MEMS display, and an electronic paper display. The display unit 420 may be implemented in various shapes.

The input unit 430 may generate input data in the electronic device 400. The input unit 430 may generate input data in response to a user input of the electronic device 400. For example, the input unit 430 may include a key pad, a dome switch, a physical button, a touch panel, a jog and shuttle, and a sensor. The input unit 430 may be implemented as a touch screen while being coupled to the display unit 420.

The storage unit 440 may store operation programs of the electronic device 400. The storage unit 440 may store a program for executing various functions. The storage unit 440 may store a program for displaying a screen according to a function to be executed. The function may be an application and include a plurality of driving engines. The storage unit 440 may store data generated while the programs are executed.

The controller 450 may control an overall operation of the electronic device 400. The controller 450 may include at least one function processor. Each function processor may execute each of the functions. Each function processor may be an AP. The controller 450 may include at least one modem.

The controller 450 may include at least one modem. The modem may convert an electric signal. The modem may convert the electrical signal according to a supported communication scheme. The modem may receive the electrical signal from the wireless processor 530 and demodulate the electrical signal. The modem may convert an analog electric signal into a digital electrical signal. On the other hand, the modem may modulate the electrical signal and transmit the modulated electrical signal to the wireless processor 530. The modem may convert a digital electrical signal into an analog electrical signal.

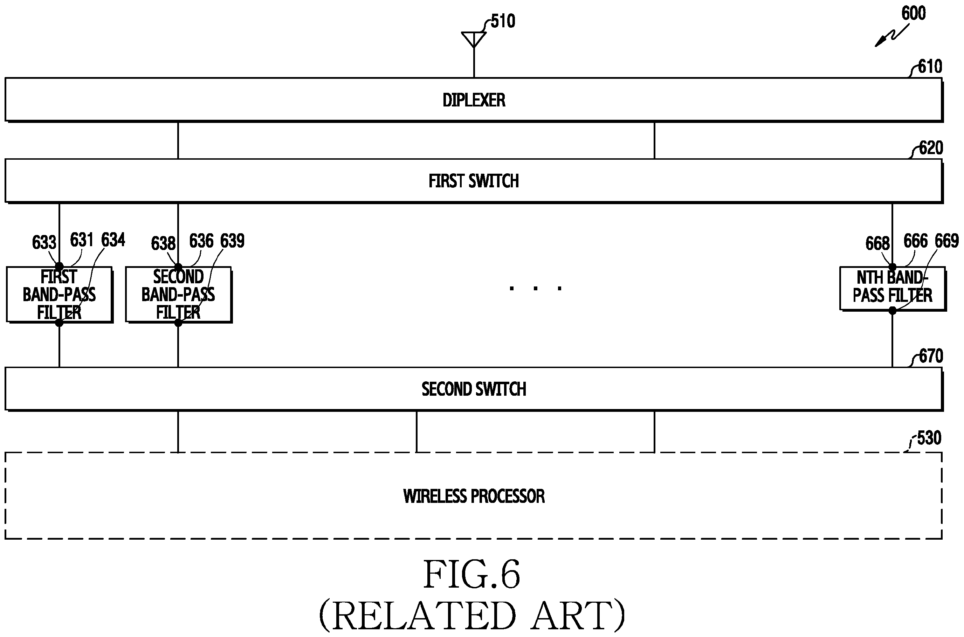

FIG. 6 is a block diagram of an antenna connection unit in an electronic device according to technology of related art.

Referring to FIG. 6, the antenna connection unit 600 may include a diplexer 610, a first switch 620, a plurality of, for example, n number of band-pass filters 631, 636, and 666 and a second switch 670.

The diplexer 610 may filter a wireless signal received from the antenna 510. The diplexer 610 may separate the wireless signal based on a pre-determined frequency. The diplexer 610 may allow two frequency bands in the wireless signal to pass therethrough. At this time, the frequency bands of the diplexer 610 may be spaced apart to each other in the frequency domain. A frequency interval of the frequency bands of the diplexer 610 may be relatively wide. For example, the diplexer 610 may include a low pass filter (LPF) and a high pass filter (HPF). The LPF may allow a relatively low frequency band in the wireless signal to pass therethrough, on the basis of a predetermined frequency. The HPF may allow a relatively high frequency band in the wireless signal to pass therethrough, on the basis of a predetermined frequency.

The first switch 620 may control the connection between the diplexer 610 and the band-pass filters 631, 636, and 666. The first switch 620 may connect the diplexer 610 to at least one of the band-pass filters 631, 636, and 666. For example, the first switch 620 may connect any one of the LPF and HPF to any one of the band-pass filters 631, 636, and 666. On the other hand, the first switch 620 may connect the LPF to any one of the band-pass filters 631, 636, and 666, and connect the HPF to another one of the band-pass filters 631, 636, and 666. The first switch 620 may transmit the wireless signal from the diplexer 610 to at least one of the band-pass filters 631, 636, and 666.

The band-pass filters 631, 636, and 666 may filter the wireless signal. The band-pass filters 631, 636, and 666 may have predetermined frequency bands. The frequency bands of the band-pass filters 631, 636, and 666 may be different from each other. At least any one of the band-pass filters 631, 636, and 666 may receive the wireless signal from the first switch 620. At least any one of the band-pass filters 631, 636, and 666 may allow each of the frequency bands in the wireless signal to pass therethrough. At least any one of the band-pass filters 631, 636, and 666 may transmit the wireless signal to the second switch 670. For example, each of the band-pass filters 631, 636, and 666 may be a surface acoustic wave (SAW) filter.

The band-pass filters 631, 636, and 666 may include input terminals 633, 638, and 668 and output terminals 634, 639, and 669. Each of the band-pass filters 631, 636, and 666 may include one of the input terminals 633, 638, and 668 and one of the output terminals 634, 639, and 669. The input terminals 633, 638, and 668 may be connected to the first switch 620. The input terminals 633, 638, and 668 may input the wireless signal from the first switch 620 to the band-pass filters 631, 636, and 666. The output terminals 634, 639, and 669 may be connected to the second switch 670. The output terminals 634, 639, and 669 may output the wireless signal from the band-pass filters 631, 636, and 666 to the second switch 670.

The second switch 670 may control the connection between the band-pass filters 631, 636, and 666 and the wireless processor 530. The second switch 670 may connect at least any one of the band-pass filters 631, 636, and 666 to the wireless processor 530. The second switch 670 may transmit the wireless signal from at least any one of the band-pass filters 631, 636, and 666 to the wireless processor 530.

According to the technology of the related art, the band-pass filters 631, 636, and 666 may be independently implemented in the antenna connection unit 600. In this case, when implementing the antenna connection unit 600, it is necessary to secure a space required for the arrangement of the band-pass filters 631, 636, and 666. This is due to the fact that separate wirings for the band-pass filters 631, 636, and 666 are required.

On the other hand, according to the technology of the related art, the first switch 620, a plurality of band-pass filters 631, 636, and 666, and the second switch 670 may be implemented in one package on the antenna connection unit 600. To this end, the antenna connection unit 600 may further include a mount board (not shown), and the first switch 620, a plurality of band-pass filters 631, 636, and 666, and the second switch 670 may be mounted on the mount board. In this case, the manufacturing cost of the antenna connection unit 600 can be increased. In this case, the manufacturing cost of the antenna connection unit 600 can be increased by the price of the mount board.

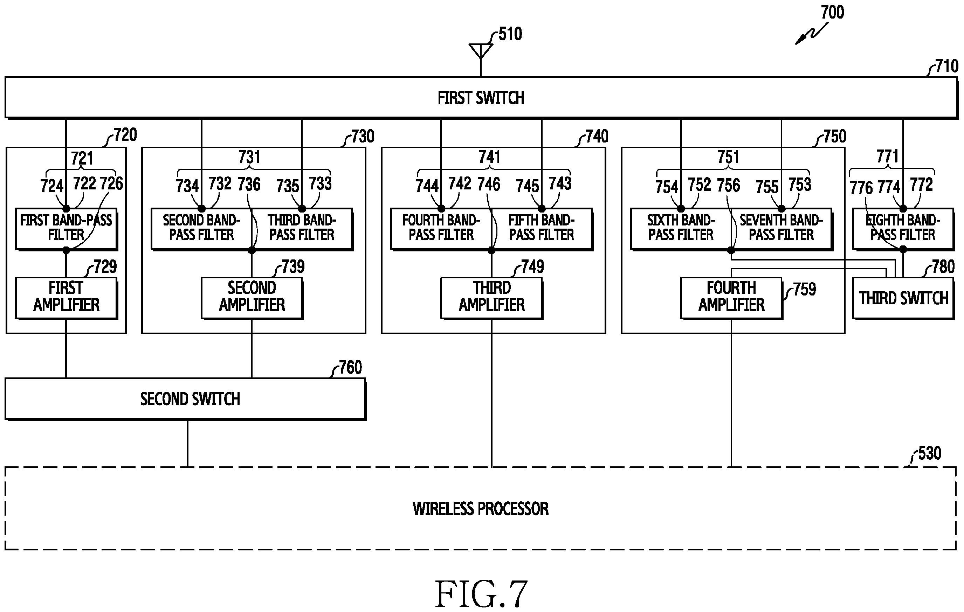

FIG. 7 is a block diagram of an antenna connection unit in an electronic device according to a first embodiment of the present disclosure.

Referring to FIG. 7, the antenna connection unit 700 may include a first switch 710, a plurality of filtering modules 720, 730, 740, 750, and second switch 760.

The first switch 710 may control the connection between the antenna 510 and the filtering modules 720, 730, 740, and 750. The first switch 710 may connect the antenna 510 to any one of the filtering modules 720, 730, 740, and 750. The first switch 710 may transmit the wireless signal from the antenna 510 to any one of the filtering modules 720, 730, 740, and 750.

The filtering modules 720, 730, 740, and 750 may filter the wireless signal. The filtering modules 720, 730, 740, and 750 may have predetermined frequency bands. The frequency bands of the filtering modules 720, 730, 740, and 750 may be different from each other. The frequency bands of the filtering modules 720, 730, 740, and 750 may be spaced apart from each other and adjacent to each other in the frequency domain. The frequency bands of the filtering modules 720, 730, 740, and 750 may be relatively narrow or wide.

Each of the filtering modules 720, 730, 740, and 750 may have at least two frequency bands. In each of the filtering modules 720, 730, 740, and 750, the frequency bands may be different from each other. In each of the filtering modules 720, 730, 740, and 750, the frequency bands may be adjacent to each other in a frequency domain. In each of the filtering modules 720, 730, 740, and 750, the frequency interval of the frequency bands may be relatively narrow. Each of the filtering modules 720, 730, 740, and 750 may include filter units 721, 731, 741, and 751 and amplifiers 729, 739, 749, and 759.

For example, the filtering modules 720, 730, 740, and 750 may include a first filtering module 720, a second filtering module 730, a third filtering module 740, and a fourth filtering module 750. The first filtering module 720 may include a first filter unit 721 and a first amplifier 729. The second filtering module 730 may include a second filter unit 731 and a second amplifier 739. The third filtering module 740 may include a third filter unit 741 and a third amplifier 749. The fourth filtering module 750 may include a fourth filter unit 751 and a fourth amplifier 759.

Each of the filter units 721, 731, 741, and 751 may include one or more band-pass filters 722, 732, 733, 742, 743, 752, and 753, one or more input terminals 724, 734, 735, 744, 745, 754, and 755, and one or more output terminals 726, 736, 746, and 756. For example, the filter units 721, 731, 741, and 751 may include one of the band-pass filters 722, 732, 733, 742, 743, 752, and 753, one of the input terminals 724, 734, 735, 744, 745, 754, and 755, and one of the output terminals 726, 736, 746, and 756. On the other hand, the filter units 721, 731, 741, and 751 may include a plurality of band-pass filters 722, 732, 733, 742, 743, 752, and 753, a plurality of input terminals 724, 734, 735, 744, 745, 754, and 755, and one of the output terminals 726, 736, 746, and 756. In one of the filter units 721, 731, 741, and 751, the band-pass filters 722, 732, 733, 742, 743, 752, and 753 may be physically combined. In one of the filter units 721, 731, 741, and 751, the band-pass filters 722, 732, 733, 742, 743, 752, and 753 may be arranged in parallel.

The band-pass filters 722, 732, 733, 742, 743, 752, and 753 may filter the wireless signal. The band-pass filters 722, 732, 733, 742, 743, 752, and 753 may have predetermined frequency bands. Frequency bands of the band-pass filters 722, 732, 733, 742, 743, 752, and 753 may be different from each other. Any one of the band-pass filters 722, 732, 733, 742, 743, 752, and 753 may receive the wireless signal from the first switch 710. Any one of the band-pass filters 722, 732, 733, 742, 743, 752, and 753 may allow each of the frequency bands in the wireless signal to pass therethrough. At least one of the band-pass filters 722, 732, 733, 742, 743, 752, and 753 may transmit the wireless signal to the amplifiers 729, 739, 749, and 759. For example, each of the band-pass filters 722, 732, 733, 742, 743, 752, and 753 may be a surface acoustic wave filter.

The input terminals 724, 734, 735, 744, 745, 754, and 755 may be connected to the band-pass filters 722, 732, 733, 742, 743, 752, and 753. In each of the filter units 721, 731, 741, and 751, the input terminals 724, 734, 735, 744, 745, 754, and 755 may be connected to the band-pass filters 722, 732, 733, 742, 743, 752, and 753, respectively. The input terminals 724, 734, 735, 744, 745, 754, and 755 may be connected to the first switch 710. The input terminals 724, 734, 735, 744, 745, 754, and 755 may input the wireless signal from the first switch 710 to the band-pass filters 722, 732, 733,742, 743, 752, and 753. The input terminals 724, 734, 735, 744, 745, 754, and 755 may input the wireless signal to the band-pass filters 722, 732, 733, 742, 743, 752, and 753, respectively.

The output terminals 726, 736, 746, and 756 may be connected to the band-pass filters 722, 732, 733, 742, 743, 752, and 753. In each of the filter units 721, 731, 741, and 751, the output terminals 726, 736, 746, and 756 may be connected to the band-pass filters 722, 732, 733, 742, 743, 752, and 753, respectively. The output terminals 726, 736, 746, and 756 may be connected to the amplifiers 729, 739, 749, and 759. The output terminals 726, 736, 746, and 756 may output the wireless signal from the band-pass filters 722, 732, 733, 742, 743, 752, and 753 to the amplifiers 729, 739, 749, and 759. In each of the filter units 721, 731, 741, and 751, the output terminals 726, 736, 746, and 756 may output the wireless signal from one of the band-pass filters 722, 732, 733, 742, 743, 752, and 753 to each of the amplifiers 729, 739, 749, and 759.

For example, the first filter unit 721 may include a first band-pass filter 722, a first input terminal 724, and a first output terminal 726. The frequency band of the first band-pass filter 722 may be B28. The first input terminal 724 may be connected to the first band-pass filter 722. The first output terminal 726 may be connected to the first band-pass filter 722.

The second filter unit 731 may include a second band-pass filter 732, a third band-pass filter 733, second input terminals 734 and 735, and a second output terminal 736. The second band-pass filter 732 and the third band-pass filter 733 may be physically coupled. The frequency band of the second band-pass filter 732 may be B5, and the frequency band of the third band-pass filter 732 may be B8. Here, since B5 is approximately 850 MHz and B8 is approximately 900 MHz, the B5 and B8 are adjacent to each other, so that the second band-pass filter 732 and the third band-pass filter 733 in the second filter unit 731 may be implemented in combination thereof. The second input terminals 734 and 735 may be individually connected to the second band-pass filter 732 and the third band-pass filter 733. The second output terminals 736 may be connected to both the second band-pass filter 732 and the third band-pass filter 733.

The third filter unit 741 may include a fourth band-pass filter 742, a fifth band-pass filter 743, third input terminals 744 and 745, and a third output terminal 736. The fourth band-pass filter 742 and the fifth band-pass filter 743 may be physically coupled. The frequency band of the fourth band-pass filter 742 may be B1, and the frequency band of the fifth band-pass filter 743 may be B3. Here, since B1 is approximately 2.1 GHz and B3 is approximately 1.8 GHz, the B1 and B3 are adjacent to each other, so that the fourth band-pass filter 742 and the fifth band-pass filter 743 in the third filter unit 741 may be implemented in combination thereof. Third input terminals 744 and 745 may be individually connected to the fourth band-pass filter 742 and the fifth band-pass filter 743. The third output terminal 746 may be connected to both the fourth band-pass filter 742 and the fifth band-pass filter 743.

The fourth filter unit 751 may include a sixth band-pass filter 752, a seventh band-pass filter 753, fourth input terminals 754 and 755, and a fourth output terminal 756. The sixth band-pass filter 752 and the seventh band-pass filter 753 may be physically coupled. The frequency band of the sixth band-pass filter 752 may be B5, and the frequency band of the seventh band-pass filter 753 may be B7. Fourth input terminals 754 and 755 may be individually connected to the sixth band-pass filter 752 and the seventh band-pass filter 753. The fourth output terminal 756 may be connected to both the sixth band-pass filter 752 and the seventh band-pass filter 753.

Amplifiers 729, 739, 749, and 759 may amplify a wireless signal. The amplifiers 729, 739, 749, and 759 may be coupled to the output terminals 726, 736, 746, and 756. In each of the filter units 721, 731, 741, and 751, amplifiers 729, 739, 749, and 759 may be connected to the output terminals 726, 736, 746, and 756, respectively. Each of the amplifiers 729, 739, 749, and 759 may receive the wireless signal from each of the output terminals 726, 736, 746, and 756. Each of the amplifiers 729, 739, 749, and 759 may receive a wireless signal from any one of the band-pass filters 722, 732, 733, 742, 743, 752, and 753. Each of the amplifiers 729, 739, 749, and 759 may amplify the wireless signal. Each of the amplifiers 729, 739, 749, and 759 may transmit the wireless signal to the wireless processor 530. Each of the amplifiers 729, 739, 749, and 759 may transmit the wireless signal to the second switch 760. For example, each of the amplifiers 729, 739, 749, and 759 may be an LNA.

The second switch 760 may control the connection between the filtering modules 720, 730, 740, and 750 and the wireless processor 530. The second switch 760 may control the connection between at least two of the filtering modules 720, 730, 740, and 750 and the wireless processor 530. The second switch 760 may connect at least any one of the filtering modules 720, 730, and 740 to the wireless processor 530. The second switch 760 may connect any one of the amplifiers 729, 739, 749, and 759 to the wireless processor 530. The second switch 760 may transmit the wireless signal from any one of the amplifiers 729, 739, 749, and 759 to the wireless processor 530.

The antenna connection unit 700 may further include at least another filter unit 771 and a third switch 780. In this case, the first switch 710 may control the connection between the antenna 510 and the filtering modules 720, 730, 740, and 750, and also may control the connection between the antenna 510 and the another filter unit 771. The first switch 710 may connect the antenna 510 to any one of the filtering modules 720, 730, 740, and 750 or the another filter unit 771. The first switch 710 may transmit the wireless signal from the antenna 510 to any one of the filtering modules 720, 730, 740, and 750 or the another filter unit 771.

The another filter unit 771 may filter the wireless signal. The another filter unit 771 may have a pre-determined frequency band. The frequency band of the another filter unit 771 may be different from the frequency bands of the filtering modules 720, 730, 740, and 750. The another filter unit 771 may include at least one band-pass filter 772, at least one input terminal 774, and one output terminal 776. For example, the another filter unit 771 may include one band-pass filter 772, one input terminal 774, and one output terminal 776.

The band-pass filter 772 may filter the wireless signal. The band-pass filter 772 may have a pre-determined frequency band. The frequency band of the band-pass filter 772 may be different from the frequency bands of the filtering modules 720, 730, 740, and 750. The band-pass filter 772 may receive the wireless signal from the first switch 710. The band-pass filter 772 may allow the corresponding frequency band in the wireless signal to pass therethrough. For example, the band-pass filter 772 may be a surface acoustic wave filter. The input terminal 774 may be connected to the band-pass filter 772. The input terminal 774 may be connected to the first switch 710. The input terminal 774 may input the wireless signal from the first switch 710 to the band-pass filter 772. The output terminal 776 may be connected to the band-pass filter 772. The output terminal 776 may be connected to the third switch 780. The output terminal 776 may output the wireless signals from the band-pass filter 772 to the third switch 780.

For example, the another filter unit 771 may be an eighth filter unit 771, and include an eighth band-pass filter 772, an eighth input terminal 774, and an eighth output terminal 776. The frequency band of the eighth band-pass filter 772 may be B40. The eighth input terminal 774 may be connected to the eighth band-pass filter 772. The eight output terminal 776 may be connected to the eight band-pass filter 772.

The third switch 780 may control the connection between at least any one of the filtering modules 720, 730, 740, and 750 and the wireless processor 771. The third switch 780 may control the connection between the filter unit 721, 731, 741, and 751 of any one of the filtering modules 720, 730, 740, and 750 and the amplifiers 729, 739, 749, and 759, and the connection between the another filter unit 771 and the amplifiers 729, 739, 749, and 759 of any one of the filtering modules 720, 730, 740, and 750. The third switch 780 may connect the filter unit 721, 731, 741, and 751 of any one of the filtering modules 720, 730, 740, and 750 or connect another filter unit 771 to the amplifiers 729, 739, 749, and 759 of any one of the filtering modules 720, 730, 740, and 750.

The third switch 780 may control the connection between the fourth filtering module 750 and the eighth filter unit 771. The third switch 780 may control the connection between the fourth filter unit 751 of the fourth filtering module 750 and the eighth filter unit 771 and the fourth amplifier 759. The third switch 780 may connect any one of the fourth output terminal 756 or the eighth output terminal 776 to the fourth amplifier 759. When the third switch 780 connects the fourth output terminal 756 to the fourth amplifier 759, the fourth output terminal 756 may output the wireless signal from the fourth filter unit 751 to the third switch 780. On the other hand, when the third switch 780 connects the eighth output terminal 776 to the fourth amplifier 759, the eighth output terminal 776 may output the wireless signal from the eighth filter unit 771 to the third switch 780. Accordingly, the third switch 780 may transmit the wireless signal from any one of the fourth filter unit 751 or the eighth filter unit 771 to the fourth amplifier 759.

According to the first embodiment of the present disclosure, the filtering modules 720, 730, 740, and 750 may include a plurality of band-pass filters 722, 732, 733, 742, 743, 752, and 753. In addition, in the filtering modules 720, 730, 740, and 750, the band-pass filters 722, 732, 733, 742, 743, 752, and 753 may be physically coupled. Accordingly, when implementing the antenna connection unit 700, a space for the arrangement of the band-pass filters 722, 732, 733, 742, 743, 752, and 753 can be reduced. In addition, even if the mount board for mounting the band-pass filters 722, 732, 733, 742, 743, 752, and 753 is not prepared, an antenna connection unit 700 can be implemented. Accordingly, the manufacturing cost of the antenna connection unit 700 can be reduced.

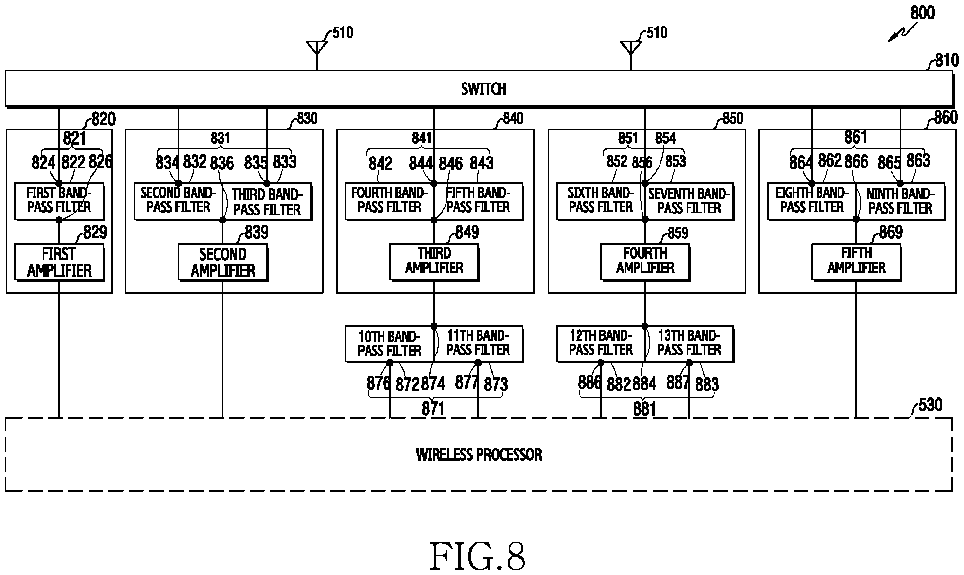

FIG. 8 is a block diagram of an antenna connection unit in an electronic device according to a second embodiment of the present disclosure. The electronic device according to the second embodiment of the present disclosure may support LTE and perform CA. The electronic device 400 may communicate by simultaneously using carriers of different frequency bands.

Referring to FIG. 8, the antenna connection unit 800 may include a first switch 810, a plurality of filtering modules 820, 830, 840, 850, and 860, and one or more additional filter units 871 and 881.

The first switch 810 may control the connection between antennas 510 and filtering modules 820, 830, 840, 850, and 860. The first switch 810 may connect at least two antennas 510 to two or more of the filtering modules 820, 830, 840, 850, and 860. The first switch 810 may transmit the wireless signal from the antennas 510 to at least two of the filtering modules 820, 830, 840, 850, and 860.

The filtering modules 820, 830, 840, 850, and 860 may filter the wireless signal. The filtering modules 820, 830, 840, 850, and 860 may have predetermined frequency bands. The frequency bands of the filtering modules 820, 830, 840, 850, and 860 may be different from each other. The frequency bands of the filtering modules 820, 830, 840, 850, and 860 may be spaced apart from each other and adjacent to each other in the frequency domain. The frequency interval of the frequency bands of the filtering modules 820, 830, 840, 850, and 860 may be relatively narrow or wide.

Each of the filtering modules 820, 830, 840, 850, and 860 may have at least two frequency bands. In each of the filtering modules 820, 830, 840, 850, and 860, the frequency bands may be different from each other. In each of the filtering modules 820, 830, 840, 850, and 860, the frequency bands may be adjacent to each other in the frequency domain. In each of the filtering modules 820, 830, 840, 850, and 860, the frequency interval of the frequency bands may be relatively narrow. Each of the filtering modules 820, 830, 840, 850, and 860 may include the filter units 821, 831, 841, 851, and 861 and amplifiers 829, 839, 849, 859, and 869.

For example, the filtering modules 820, 830, 840, 850, and 860 may include a first filtering module 820, a second filtering module 830, a third filtering module 840, a fourth filtering module 850, and a fifth filtering module 860. The first filtering module 820 may include a first filter unit 821 and a first amplifier 829. The second filtering module 830 may include a second filter unit 831 and a second amplifier 839. The third filtering module 840 may include a third filter unit 841 and a third amplifier 849. The fourth filtering module 850 may include a fourth filter unit 851 and a fourth amplifier 859. The fifth filtering module 860 may include a fifth filter unit 861 and a fifth amplifier 869.

Each of the filter units 821, 831, 841, 851, and 861 may include one or more band-pass filters 822, 832, 833, 842, 843, 852, 853, 862, and 863, one or more input terminal 824, 834, 835, 844, 845, 854, 864, and 865, and one of the output terminals 826, 836, 846, 856, and 866. For example, the filter units 821, 831, 841, 851, and 861 may include one of the band-pass filters 822, 832, 833, 842, 843, 852, 853, 862, and 863, one of the input terminals 824, 834, 835, 844, 845, 854, 864, and 865, and one of the output terminals 826, 836, 846, 856, and 866. On the other hand, the filter units 821, 831, 841, 851, and 861 may include a plurality of band-pass filters 822, 832, 833, 842, 843, 852, 853, 862, and 863, one of the input terminals 824, 834, 835, 844, 845, 854, 864, and 865, and one of the output terminals 826, 836, 846, 856, and 866. On the other hand, the filter units 821, 831, 841, 851, and 861 may include a plurality of band-pass filters 822, 832, 833, 842, 843, 852, 853, 862, and 863, a plurality of input terminal 824, 834, 835, 844, 845, 854, 864, and 865, and one of the output terminals 826, 836, 846, 856, and 866. In one of the filter units 821, 831, 841, 851, and 861, the band-pass filters 822, 832, 833, 842, 843, 852, 853, 862, and 863 may be physically coupled. In one of the filter units 821, 831, 841, 851, and 861, the band-pass filters 822, 832, 833, 842, 843, 852, 853, 862, and 863 may be arranged in parallel.

The band-pass filters 822, 832, 833, 842, 843, 852, 853, 862, and 863 may filter the wireless signal. The band-pass filters 822, 832, 833, 842, 843, 852, 853, 862, and 863 may have predetermined frequency bands. Frequency bands of the band-pass filters 822, 832, 833, 842, 843, 852, 853, 862, and 863 may be different from each other. Any one of the band-pass filters 822, 832, 833, 842, 843, 852, 853, 862, and 863 may receive the wireless signal from the first switch 810. Any one of the band-pass filters 822, 832, 833, 842, 843, 852, 853, 862, and 863 may allow each of the frequency bands in the wireless signal to pass therethrough. At least one of the band-pass filters 822, 832, 833, 842, 843, 852, 853, 862, and 863 may transmit the wireless signal to the amplifiers 829, 839, 849, 859, and 869. For example, each of the band-pass filters 822, 832, 833, 842, 843, 852, 853, 862, and 863 may be a surface acoustic wave filter.

The input terminals 824, 834, 835, 844, 845, 854, 864, and 865 may be connected to the band-pass filters 822, 832, 833, 842, 843, 852, 853, 862, and 863. In each of the filter units (821, 831, 841, 851, and 861), the input terminals 824, 834, 835, 844, 845, 854, 864, and 865 may be connected to the band-pass filters 822, 832, 833, 842, 843, 852, 853, 862, and 863, respectively. On the other hand, in each of the filter units (821, 831, 841, 851, and 861), the input terminals 824, 834, 835, 844, 845, 854, 864, and 865 may be connected to the band-pass filters 822, 832, 833, 842, 843, 852, 853, 862, and 863. The input terminals 824, 834, 835, 844, 845, 854, 864, and 865 may be connected to the first switch 810. The input terminals 824, 834, 835, 844, 845, 854, 864, and 865 may input the wireless signal from the first switch 810 to the band-pass filters 822, 832, 733,742, 842, 852, 853, 862, and 863. Each of the input terminals 824, 834, 835, 844, 845, 854,864, and 865 may input the wireless signal to at least one of the band-pass filters 822, 832, 833, 842, 843, 852, 853, 862, and 863.

The output terminals 826, 836, 846, 856, and 866 may be connected to the band-pass filters 822, 832, 833, 842, 843, 852, 853, 862, and 863. In each of the filter units (821, 831, 841, 851, and 861), each of the output terminals 826, 836, 846, 856, and 866 may be connected to the band-pass filters 822, 832, 833, 842, 843, 852, 853, 862, and 863. The output terminals 826, 836, 846, 856, and 866 may be connected to the amplifiers 829, 839, 849, 859, and 869. The output terminals 826, 836, 846, 856, and 866 may output the wireless signal from the band-pass filters 822, 832, 833, 842, 843, 852, 853, 862, and 863 to the amplifiers 829, 839, 849, 859, and 869. In each of the filter units 821, 831, 841, 851, and 861, each of the output terminals 826, 836, 846, 856, and 866 may output the wireless signal from one of the band-pass filters 822, 832, 833, 842, 843, 852, 853, 862, and 863 to each of the amplifiers 829, 839, 849, 859, and 869.

For example, the first filter unit 821 may include a first band-pass filter 822, a first input terminal 824, and a first output terminal 826. The frequency band of the first band-pass filter 822 may be B28. The first input terminal 824 may be connected to the first band-pass filter 822. The first output terminal 826 may be connected to the first band-pass filter 822.

The second filter unit 831 may include a second band-pass filter 832, a third band-pass filter 833, second input terminals 834 and 835, and a second output terminal 836. The second band-pass filter 832 and the third band-pass filter 833 may be physically coupled. The frequency band of the second band-pass filter 832 may be B12, and the frequency band of the third band-pass filter 833 may be B28. On the other hand, the frequency band of the second band-pass filter 832 may be B20, and the frequency band of the third band-pass filter 833 may be B28. On the other hand, the frequency band of the second band-pass filter 832 may be B5, and the frequency band of the third band-pass filter 833 may be B8. Here, since B5 is approximately 850 MHz and B8 is approximately 900 MHz, the B5 and B8 are adjacent to each other, so that the second band-pass filter 832 and the third band-pass filter 833 in the second filter unit 831 may be implemented in combination thereof. The second input terminals 834 and 835 may be individually connected to the second band-pass filter 832 and the third band-pass filter 833. The second output terminals 836 may be connected to both the second band-pass filter 832 and the third band-pass filter 833.

The third filter unit 841 may include a fourth band-pass filter 842, a fifth band-pass filter 843, a third input terminal 844, and a third output terminal 846. The fourth band-pass filter 842 and the fifth band-pass filter 843 may be physically coupled. The frequency band of the fourth band-pass filter 842 may be B2, and the frequency band of the fifth band-pass filter 843 may be B4. Here, since B2 is approximately 1.9 GHz and B4 is approximately 1.8 GHz, the B2 and B4 are adjacent to each other, so that the fourth band-pass filter 842 and the fifth band-pass filter 843 in the third filter unit 841 may be implemented in combination thereof. The third input terminal 844 may be connected to both the fourth band-pass filter 842 and the fifth band-pass filter 843. The third output terminal 846 may be connected to both the fourth band-pass filter 842 and the fifth band-pass filter 843.

The fourth filter unit 851 may include a sixth band-pass filter 852, a seventh band-pass filter 853, a fourth input terminal 854, and a fourth output terminal 856. The sixth band-pass filter 852 and the seventh band-pass filter 853 may be physically coupled. The frequency band of the sixth band-pass filter 852 may be B1, and the frequency band of the seventh band-pass filter 853 may be B3. Here, since B1 is approximately 2.1 GHz and B3 is approximately 1.8 GHz, the B1 and B3 are adjacent to each other, so that the sixth band-pass filter 852 and the seventh band-pass filter 853 in the fourth filter unit 851 may be implemented in combination thereof. The fourth input terminal 854 may be connected to both the sixth band-pass filter 852 and the seventh band-pass filter 853. The fourth output terminal 856 may be connected to both the sixth band-pass filter 852 and the seventh band-pass filter 853.

The fifth filter unit 861 may include an eighth band-pass filter 862, a ninth band-pass filter 863, fifth input terminals 864 and 865, and a fifth output terminal 866. The eighth band-pass filter 862 and the ninth band-pass filter 863 may be physically coupled. The frequency band of the eighth band-pass filter 862 may be B7, and the frequency band of the ninth band-pass filter 863 may be B40. Here, since B7 is approximately 2.6 GHz and B40 is approximately 2.3 GHz, the B7 and B40 are adjacent to each other, so that the eighth band-pass filter 862 and the ninth band-pass filter 863 in the fifth filter unit 861 may be implemented in combination thereof. The fifth input terminals 864 and 865 may be individually connected to the eighth band-pass filter 862 and the ninth band-pass filter 863. The fifth output terminal 866 may be connected to both the eighth band-pass filter 862 and the ninth band-pass filter 863.

Amplifiers 829, 839, 849, 859, and 869 may amplify a wireless signal. The amplifiers 829, 839, 849, 859, and 869 may be connected to the output terminals 826, 836, 846, 856, and 866. In each of the filter units 821, 831, 841, 851, and 861, amplifiers 829, 839, 849, 859, and 869 may be connected to the output terminals 826, 836, 846, 856, and 866, respectively. Each of the amplifiers 829, 839, 849, 859, and 869 may receive the wireless signal from each of the output terminals 826, 836, 846, 856, and 866. Each of the amplifiers 829, 839, 849, 859, and 869 may receive the wireless signal from any one of the band-pass filter 822, 832, 833, 842, 843, 852, 853, 862, and 863. Each of the amplifiers 829, 839, 849, 859, and 869 may amplify the wireless signal. Each of the amplifiers 829, 839, 849, 859, and 869 may transmit the wireless signal to the wireless processor 530. On the other hand, each of the amplifiers 829, 839, 849, 859, and 869 may transmit the wireless signal to the additional filter units 871 and 881. For example, each of the amplifiers 829, 839, 849, 859, and 869 may be a low noise amplifier.

The additional filter units 871 and 881 may filter the wireless signal once more. The additional filter units 871 and 881 may be disposed between the filtering modules 820, 830, 840, 850, 860 and the wireless processor 530. Each of the additional filter units 871 and 881 may be disposed between any one of the filtering modules 820, 830, 840, 850, and 860 having a plurality of band-pass filters 822, 832, 833, 842, 843, 852, 853, 862, and 863 therein and the wireless processor 530. The additional filter units 871 and 881 may have pre-determined frequency bands. The additional filter units 871 and 881 may have at least two frequency bands. In the additional filter units 871 and 881, the frequency bands may be different from each other.

The additional filter units 871 and 881 may include a plurality of additional band-pass filters 872, 873, 882, and 883, one of the additional input terminals 874 and 884, and a plurality of additional output terminals 866, 867, 876, 877, 886, and 887. In the additional filter units 871 and 881, additional band-pass filters 872, 873, 882, and 883 may be physically coupled. In the additional filter units 871 and 881, the additional band-pass filters 872, 873, 882, and 883 may be coupled in parallel.

The additional band-pass filters 872, 873, 882, and 883 may filter the wireless signal. The additional band-pass filters 872, 873, 882, and 883 may have predetermined frequency bands. The frequency bands of the band-pass filters 872, 873, 882, and 883 may be different from each other. When the additional filter units 871 and 881 are connected to any one of the filtering modules 820, 830, 840, 850, and 860 having a plurality of band-pass filters 822, 832, 833, 842, 843, 852, 853, 862, and 863 therein, the frequency bands of additional band-pass filters 872, 873, 882, and 883 may be the same as those of the corresponding band-pass filters 822, 832, 833, 842, 843, 852, 853, 862, and 863. Any one of the additional band-pass filters 872, 873, 882, and 883 may receive the wireless signal from any one of the filtering modules 820, 830, 840, 850, and 860. Any one of the additional band-pass filters 872, 873, 882, and 883 may allow each of the frequency bands in the wireless signal to pass therethrough. At least any one of the additional band-pass filters 872, 873, 882, and 883 may transmit the wireless signal to the wireless processor 530. For example, each of the band-pass filters 872, 873, 882, and 883 may be a surface acoustic wave filter.

The additional input terminals 874 and 884 may be connected to the additional band-pass filter 872, 873, 882, and 883. In the additional filter units 871 and 881, the additional input terminals 874 and 884 may be connected to the additional band-pass filters 872, 873, 882, and 883. The additional input terminals 874 and 884 may be connected to any one of the filtering modules 820, 830, 840, 850, and 860. The additional input terminals 874 and 884 may input the wireless signal from any one of the filtering modules 820, 830, 840, 850, and 860 to the additional band-pass filters 872, 873, 882, and 883.

The additional output terminals 876, 877, 886, and 887 may be connected to the wireless processor 530. In the additional filter units 871 and 881, the additional output terminals 876, 877, and 887 may be connected to the additional band-pass filters 872, 873, 882, and 883, respectively. Any one of the additional output terminals 876, 877, 886, and 887 may output the wireless signal from any one of the additional band-pass filters 872, 873, 882, and 883 to the wireless processor 530.

For example, the additional filter units 871 and 881 may include a sixth filter unit 871 and a seventh filter unit 881. The sixth filter unit 871 may be connected to the third filtering module 840. The sixth filter unit 871 may include a 10th band-pass filter 872, an 11th band-pass filter 873, a sixth input terminal 874, and sixth output terminals 876 and 877. The 10th band-pass filter 872 and the 11th band-pass filter 873 may be physically coupled. The frequency band of the 10th band-pass filter band 872 may be the same as that of the fourth band-pass filter 842, and the frequency band of the 11th band-pass filter 873 may be the same as that of the fifth band-pass filter 843. The sixth input terminal 874 may be connected to both the 10th band-pass filter 872 and the 11th band-pass filter 873. The sixth output terminals 876 and 877 may be individually connected to the 10th band-pass filter 872 and the 11th band-pass filter 873. The seventh filter unit 881 may be connected to the fourth filtering module 850. The seventh filter unit 881 may include a 12th band-pass filter 882, a 13th band-pass filter 883, a seventh input terminal 884, and seventh output terminals 886 and 887. The 12th band-pass filter 882 and the 13th band-pass filter 883 may be physically coupled. The frequency band of the 12th band-pass filter band 882 may be the same as that of the sixth band-pass filter 852, and the frequency band of the 13th band-pass filter 883 may be the same as that of the seventh band-pass filter 853. The seventh input terminal 884 may be connected to both the 12th band-pass filter 882 and the 13th band-pass filter 883. The seventh output terminals 886 and 887 may be individually connected to the 12th band-pass filter 882 and the 13th band-pass filter 883.

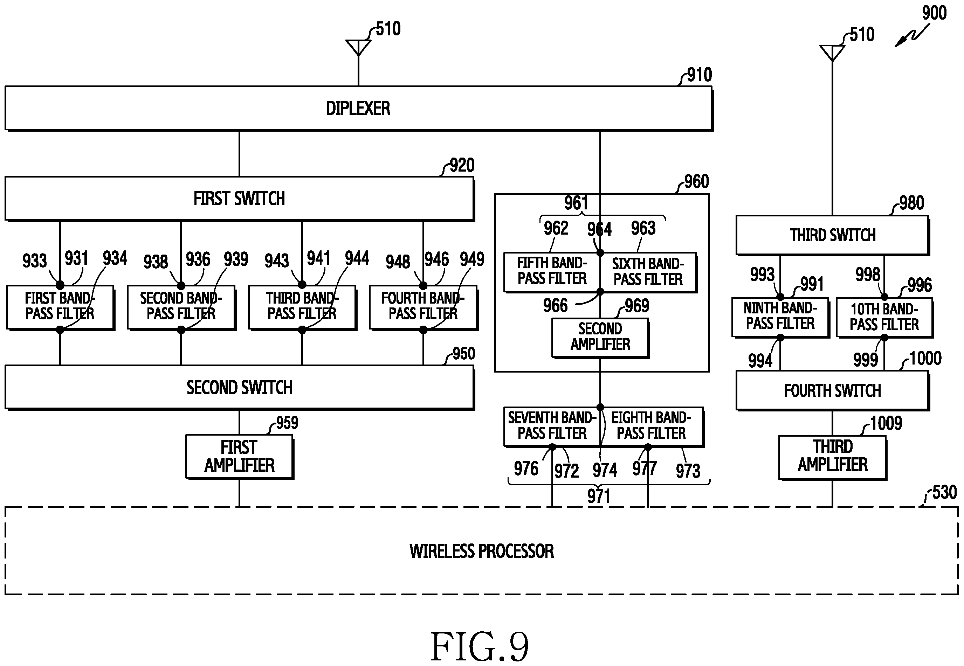

FIG. 9 is a block diagram of an antenna connection unit in an electronic device according to an embodiment of the present disclosure. The electronic device according to the embodiment of the present disclosure may support LTE and perform CA. The electronic device 400 may communicate by simultaneously using carriers of different frequency bands.

Referring to FIG. 9, an antenna connection unit 900 may include a diplexer 910, a first switch 920, a first group of band-pass filters 931, 936, 941, and 946, a second switch 950, a filtering module 960, an additional filter unit 971, a third switch 980, a second group of band-pass filters 991 and 996, a fourth switch 1000, and a third amplifier 1009.

The diplexer 910 may filter a wireless signal received from one of the antennas 510. The diplexer 910 may separate the wireless signal based on a pre-determined frequency. For example, the diplexer 910 may include an LPF and an HPF. The LPF may allow a relatively low frequency band in the wireless signal to pass therethrough, on the basis of a predetermined frequency. For example, the LPF may be connected to the first switch 920. The HPF may pass a relatively high frequency band in the wireless signal, on the basis of a predetermined frequency. For example, the HPF may be connected to the filtering module 960.

The first switch 920 may control the connection between the diplexer 910 and the first group of the band-pass filters 931,936, 941, and 946. The first switch 920 may control the connection between the diplexer 910 and the band-pass filters 931, 936, 941, and 946 of the first group of the band-pass filters 931, 936, 941, and 946. The first switch 920 may connect the diplexer 910 to any one of the band-pass filters 931, 936, 941, and 946. The first switch 920 may transmit the wireless signal from the diplexer 910 to any one of the band-pass filters 931, 936, 941, and 946.

The first group of band-pass filters 931, 936, 941, and 946 may include a plurality of band-pass filters 931, 936, 941, and 946. The band-pass filters 931, 936, 941, and 946 may filter the wireless signal. The band-pass filters 931, 936, 941, and 946 may have predetermined frequency bands. The frequency bands of the band-pass filters 931, 936, 941, and 946 may be different from each other. Any one of the band-pass filters 931, 936, 941, and 946 may receive the wireless signal from the first switch 920. Any one of the band-pass filters 931, 936, 941, and 946 may allow the corresponding frequency band in the wireless signal to pass therethrough. Any one of the band-pass filters 931, 936, 941, and 946 may transmit the wireless signal to the second switch 950. For example, each of the band-pass filters 931, 936, 941, and 946 may be a surface acoustic wave filter.

The band-pass filters 931, 936, 941, and 946 may include input terminals 933, 938, 943, and 948 and output terminals 934, 939, 944, and 949. Each of the band-pass filters 931, 936, 941, and 946 may include one of the input terminals 933, 938, 943, and 948 and one of the output terminals 934, 939, 944, and 949. The input terminals 933, 938, 943, and 948 may be connected to the first switch 920. The input terminals 933, 938, 943, and 948 may input the wireless signal from the first switch 920 to the band-pass filters 931, 936, 941, and 946. The output terminals 934, 939, 944, and 949 may be connected to the second switch 950. The output terminals 934, 939, 944, and 949 may output the wireless signal from the band-pass filters 931, 936, 941, and 946 to the second switch 950.

For example, the band-pass filters 931, 936, 941, and 946 may include a first band-pass filter 931, a second band-pass filter 936, a third band-pass filter 941, and a fourth band-pass filter 946. The first band-pass filter 931 may include a first input terminal 933 and a first output terminal 934. The frequency band of the first band-pass filter 931 may be B28. The second band-pass filter 936 may include a second input terminal 938 and a second output terminal 939. The frequency band of the second band-pass filter 936 may be B20. The third band-pass filter 941 may include a third input terminal 943 and a third output terminal 944. The frequency band of the third band-pass filter 941 may be B8. The fourth band-pass filter 946 may include a fourth input terminal 948 and a fourth output terminal 949. The frequency band of the fourth band-pass filter 946 may be B5.

The second switch 950 may control the connection between the band-pass filters 931, 936, 941, and 946 and the first amplifier 959. The second switch 950 may connect any one of the band-pass filters 931, 936, 941, and 946 to the first amplifier 959. The second switch 950 may transmit the wireless signal from any one of the band-pass filters 931, 936, 941, and 946 to the first amplifier 959.

The first amplifier 959 may amplify the wireless signal. The first amplifier 959 may be connected to the second switch 950. The first amplifier 959 may receive the wireless signal from the second switch 950. The first amplifier 959 may receive the wireless signal from any one of the band-pass filters 931, 936, 941, and 946. The first amplifier 959 may amplify the wireless signal from any one of the band-pass filters 931, 936, 941, and 946. The first amplifier 959 may transmit the wireless signal to the wireless processor 530. For example, the first amplifier 959 may be a low noise amplifier.

The filtering module 960 may filter the wireless signal. The filtering module 960 may have pre-determined frequency bands. The filtering module 960 may have at least two pre-determined frequency bands. The frequency bands of the filtering module 960 may be different from each other. The frequency bands of the filtering module 960 may be spaced apart from each other and adjacent to each other in the frequency domain. A frequency interval of the frequency bands of the filtering module 960 may be relatively narrow. The filtering module 960 may include a first filter unit 961 and a second filter unit 969.

The filter unit 961 may include one or more band-pass filters 962 and 963, one input terminal 964, and one output terminal 966. For example, the filter unit 961 may include a plurality of band-pass filters 962 and 963, one input terminal 964, and one output terminal 966. The band-pass filters 962 and 963 may be physically coupled. The band-pass filters 962 and 963 may be arranged in parallel.

The band-pass filters 962 and 963 may filter the wireless signal. The band-pass filters 962 and 963 may have predetermined frequency bands. The frequency bands of the band-pass filters 962 and 963 may be different from each other. Any one of the band-pass filters 962 and 963 may receive the wireless signal from the diplexer 910. Any one of the band-pass filters 962 and 963 may allow the corresponding frequency band in the wireless signal to pass therethrough. Any one of the band-pass filters 962 and 963 may transmit the wireless signal to the second amplifier 969. For example, each of the band-pass filters 962 and 963 may be a surface acoustic wave filter.

The input terminal 964 may be connected to the band-pass filters 962 and 963. The input terminal 964 may be connected to the diplexer 910. The input terminal 964 may input the wireless signal from the diplexer 910 to the band-pass filters 962 and 963. The input terminal 964 may input the wireless signal to any one of the band-pass filters 962 and 963.

The output terminal 966 may be connected to the band-pass filters 962 and 963. The output terminal 966 may be connected to the second amplifier 969. The output terminal 966 may output the wireless signals from the band-pass filters 962 and 963 to the second amplifier 969. The output terminal 966 may output the wireless signals from any one of the band-pass filters 962 and 963 to the second amplifier 969.

For example, the filter unit 961 may include a fifth band-pass filter 962, a sixth band-pass filter 963, a fifth input terminal 964, and a fifth output terminal 966. The fifth band-pass filter 962 and the sixth band-pass filter 963 may be physically coupled. A frequency band of the fifth band-pass filter 962 may be B3 or B2, and a frequency band of the sixth band-pass filter 963 may be B1 or B4. Here, since B3 is approximately 1.8 GHz, B2 is approximately 1.9 GHz, B1 is 2.1 GHz, B4 is 1.8 GHz, and the frequency bands are adjacent to each other, the fifth band-pass filter 962 and the sixth band-pass filter 963 in the filter unit 961 may be implemented in combination thereof. The fifth input terminal 964 may be connected to both the fifth band-pass filter 962 and the sixth band-pass filter 963. The fifth output terminal 966 may be connected to both the fifth band-pass filter 962 and the sixth band-pass filter 963.

The second amplifier 969 may amplify the wireless signal. The second amplifier 969 may be connected to the output terminal 966 of the filter unit 961. The second amplifier 969 may receive the wireless signal from the output terminal 966. The second amplifier 969 may receive the wireless signal from any one of the band-pass filters 962 and 963. The second amplifier 969 may amplify the wireless signal. The second amplifier 969 may transmit the wireless signal to the additional filter unit 971. For example, the second amplifier 969 may be a low noise amplifier.

The additional filter unit 971 may filter the wireless signal once more. The additional filter unit 971 may be disposed between the filtering module 960 and the wireless processor 530. The additional filter unit 971 may have pre-determined frequency bands. The additional filter unit 971 may have at least two pre-determined frequency bands. The frequency bands of the additional filter unit 971 may be different from each other.

For example, the additional filter unit 971 may include a seventh band-pass filter 972, an eighth band-pass filter 973, a seventh input terminal 974, and seventh output terminals 976 and 977. The seventh band-pass filter 972 and the eighth band-pass filter 973 may be physically coupled. The frequency band of the seventh band-pass filter band 972 may be the same as that of the fifth band-pass filter 962, and the frequency band of the eighth band-pass filter 973 may be the same as that of the sixth band-pass filter 963. The seventh input terminal 974 may be connected to both the seventh band-pass filter 972 and the eighth band-pass filter 973. The seventh output terminals 976 and 977 may be individually connected to the seventh band-pass filter 972 and the eighth band-pass filter 973.

The third switch 980 may control the connection between another antenna of the antennas 510 and the second group of band-pass filters 991 and 996. The third switch 980 may control the connection between another antenna of the antennas 510 and the band-pass filters 991 and 996 of the second group of band-pass filters 991 and 996. The third switch 980 may connect another antenna of the antennas 510 to any one of the band-pass filters 991 and 996. The third switch 980 may transmit the wireless signal from another antenna of the antennas 510 to any one of the band-pass filters 991 and 996.

The second group of band-pass filters 991 and 996 may include a plurality of band-pass filters 991 and 996. The band-pass filters 991 and 996 may filter the wireless signal. The band-pass filters 991 and 996 may have predetermined frequency bands. The frequency bands of the band-pass filters 991 and 996 may be different from each other. Any one of the band-pass filters 991 and 996 may receive the wireless signal from the third switch 980. Any one of the band-pass filters 991 and 996 may allow the corresponding frequency band in the wireless signal to pass therethrough. Any one of the band-pass filters 991 and 996 may transmit the wireless signal to the fourth switch 1000. For example, each of the band-pass filters 991 and 996 may be a surface acoustic wave filter.

The band-pass filters 991 and 996 may include input terminals 993 and 998 and output terminals 994 and 999. Each of the band-pass filters 991 and 996 may include one of the input terminals 993 and 998 and one of the output terminals 994 and 999. The input terminals 993 and 998 may be connected to the third switch 980. The input terminals 993 and 998 may input the wireless signal from the third switch 980 to the band-pass filters 991 and 996. The output terminals 994 and 999 may output the wireless signal from the band-pass filters 991 and 996 to the fourth switch 1000.

For example, the band-pass filters 991 and 996 may include a ninth band-pass filter 991 and a 10th band-pass filter 996. The ninth band-pass filter 991 may include a ninth input terminal 993 and a ninth output terminal 994. The frequency band of the ninth band-pass filter 991 may be B7. The 10th band-pass filter 996 may include a 10th input terminal 998 and a 10th output terminal 999. The frequency band of the 10th band filter 996 may be B40.

The fourth switch 1000 may control the connection between the band-pass filters 991 and 996 and the third amplifier 1009. The fourth switch 1000 may connect any one of the band-pass filters 991 and 996 to the third amplifier 1009. The fourth switch 1000 may transmit the wireless signal from any one of the band pass filters 991 and 996 to the third amplifier 1009.

The third amplifier 1009 may amplify the wireless signal. The third amplifier 1009 may be connected to the fourth switch 1000. The third amplifier 1009 may receive the wireless signal from the fourth switch 1000. The third amplifier 1009 may receive the wireless signal from any one of the band pass filters 991 and 996. The third amplifier 1009 may amplify the wireless signal from any one of the band pass filters 991 and 996. The third amplifier 1009 may transmit the wireless signal to the wireless processor 530. For example, the third amplifier 1009 may be a low noise amplifier.

According to a second and third embodiment of the present disclosure, the filtering modules 820, 830, 840, 850, 860, and 960 may include a plurality of band-pass filters 822, 832, 833, 842, 843, 852, 853, 862, 863, 962, and 963. In addition, in the filtering modules 820, 830, 840, 850, 860, and 960, the band-pass filters 822, 832, 833, 842, 843, 852, 853, 862, 863, 962, and 963 may be physically coupled. Accordingly, when implementing the antenna connection units 800 and 900, a space for the arrangement of the band-pass filters 822, 832, 833, 842, 843, 852, 853, 862, 863, 962, and 963 can be reduced. In addition, the frequency bands of the filtering modules 820, 830, 840, 850, 860, and 960 may be adjacent to each other in the frequency domain. In each of the filtering modules 820, 830, 840, 850, 860, and 960, the frequency bands may be adjacent to each other in the frequency domain. Accordingly, the electronic device 400 may perform CA even if a frequency interval between frequency bands of carriers is relatively narrow. On the other hand, even if the mount board for mounting the band-pass filters 822, 832, 833, 842, 843, 852, 853, 862, 863, 962, and 963 is not prepared, the antenna connection units 800 and 900 can be implemented. Accordingly, the manufacturing cost of the antenna connection units 800 and 900 can be reduced.

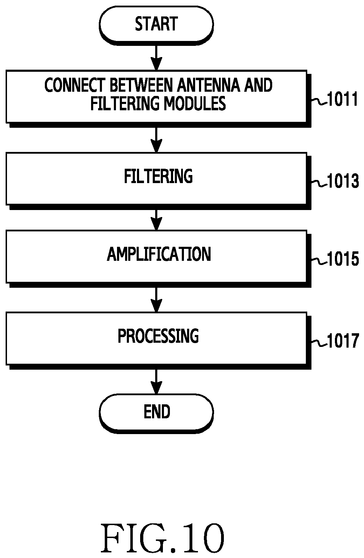

FIG. 10 is a flow chart of a receiving method of an electronic device according to various embodiments of the present disclosure.

Referring to FIG. 10, in operation 1011, the first switches 710, 810, and 910 may control the connection between the antenna 510 and the filtering modules 720, 730, 740, 750, 820, 830, 840, 850, 860, and 960.

In operation 1013, the band-pass filters 722, 732, 733, 742, 743, 752, 753, 762, 822, 832, 833, 842, 843, 852, 853, 862, 863, 962, and 963 of any one of the filtering modules 720, 730, 740, 750, 820, 830, 840, 850, 860, and 960 may filter the wireless signal. Accordingly, the band-pass filters 722, 732, 733, 742, 743, 752, 753, 762, 822, 832, 833, 842, 843, 852, 853, 862, 863, 962, and 963 may allow a predetermined frequency band in the wireless signal to pass therethrough.

In operation 1015, the amplifiers 729, 739, 749, 759, 829, 839, 849, 859, 869, and 969 of any one of the filtering modules 720, 730, 740, 750, 820, 830, 840, 850, 860, and 960 may amplify the wireless signal.

In operation 1017, the wireless signal can be processed to an electrical signal. The wireless processor 530 may receive the wireless signal from the antenna connection units 700, 800, and 900. The wireless processor 530 may convert the wireless signal into an electrical signal.

According to the second embodiment and third embodiment of the present disclosure, between operation 1015 and operation 1017, the additional filter units 871, 881, and 971 may filter a wireless signal once more. The additional filter units 871, 881, and 971 may receive a wireless signal from the filtering modules 820, 830, 840, 850, 860, and 960 and filter the wireless signal once more. The additional filter units 871, 881, and 971 may output the wireless signal to the wireless processor 530.

According to various embodiments, the antenna connection units 700, 800, and 900 can be implemented in various structures by using the filtering modules 720, 730, 740, 750, 820, 830, 840, 850, 860, and 960. That is, the filtering modules 720, 730, 740, 750, 820, 830, 840, 850, 860, and 960 can be applied to various structures of the antenna connection units 700, 800, and 900. Therefore, the electronic device 400 can support various communication schemes.

While the present disclosure has been shown and described with reference to various embodiments thereof, it will be understood by those skilled in the art that various changes in form and details may be made therein without departing from the scope of the present disclosure as defined by the appended claims.

## Claims

1. An electronic device (101) comprising:
at least one antenna (510);
at least one filtering module (840; 850; 960) configured to filter a wireless signal received from the antenna (510); and
a wireless processor (530),
wherein the at least one filtering module (840; 850; 960) comprises:
a first filter unit (841; 851; 961) comprising a first plurality of filters (842; 843; 852; 853; 962; 963) configured to pass different frequency bands which are adjacent to each other; and
an amplifier (849; 859; 969) configured to amplify the wireless signal which has passed through the first filter unit (841; 851; 961),
the electronic device further comprising a second filter unit (871; 881; 971) which is connected to the at least one filtering module (840; 850; 960), the second filter unit (871; 881; 971) being configured to receive the amplified wireless signal from the at least one filtering module (840; 850; 960) and pass a predetermined frequency band in the received wireless signal,
wherein the first plurality of filters (842; 843; 852; 853; 962; 963) are configured to share one output terminal (846; 856; 966), and each of the first plurality of filters (842; 843; 852; 853; 962; 963) is configured to connect to the amplifier (839; 849; 859; 869) through the one output terminal (846; 856; 966),
and wherein the second filter unit (871; 881; 971) comprises a second plurality of filters (872; 873; 882; 883; 972; 973) and a plurality of output terminals (876; 877; 886; 887; 976; 977), an output terminal being individually connected to each of the second plurality of filters (872, 873, 882, 883; 972, 973), and each output terminal being individually connected to the wireless processor (530).

2. The electronic device of claim 1, wherein the first plurality of filters (842; 843; 852; 853) are configured to share one input terminal (844; 854) and each of the first plurality of filters (842; 843; 852; 853) is configured to receive the wireless signal through the one input terminal (844; 854).

3. The electronic device of claim 1, wherein each of the first plurality of filters (832; 833; 862; 863) comprises different input terminals (834; 835; 864; 865), each of the first plurality of filters (832; 833; 862; 863) being configured to receive the wireless signal through the different input terminals (834; 835; 864; 865).

4. The electronic device of claim 1,
wherein the second plurality of filters (872; 873; 882; 883; 972; 973) are each configured to correspond to different frequency bands; and
wherein frequency bands of the second plurality of filters are equal to frequency bands of the first plurality of filters (842; 843; 852; 853; 962; 963) included in the filtering module (840; 850; 960) which is coupled to the second filter unit (871; 881; 971).

5. The electronic device of claim 4, wherein the second plurality of filters (872; 873; 882; 883; 972; 973) are configured to share one input terminal (874; 884; 974), and each of the second plurality of filters (872; 873; 882; 883; 972; 973) is configured to connect the amplifier (849; 859; 969) through the one input terminal (874; 884; 974).

6. The electronic device of claim 1, further comprising:
a switch (810) configured to control the connection between the antenna (510) and the filtering module (840; 850; 960).

7. A method of an electronic device (101) having at least one antenna (510) and a wireless processor (530), the method comprising:
connecting at least one filtering module (840; 850; 960) to the antenna (510) (operation 1011);
filtering, by a first filter unit (841; 851; 961) of the at least one filtering module (840; 850; 960), a wireless signal received from the antenna (510) (operation 1013);
amplifying, by an amplifier (849; 859; 969) connected to the first filter unit (841; 851; 961), the wireless signal which has passed through the first filter unit (841; 851; 961) (operation 1015); and
filtering, by a second filter unit (871; 881; 971) connected to the amplifier (839; 849; 859; 869), the amplified wireless signal,
wherein the at least one filtering module (840; 850; 960) comprises:
the first filter unit (841; 851; 961) comprising a plurality of filters (842; 843; 852; 853; 962; 963) configured to pass different frequency bands which are adjacent to each other; and
the amplifier (849; 859; 969) configured to amplify the wireless signal which has passed through the first filter unit (841; 851; 961),
wherein the plurality of filters (842; 843; 852; 853; 962; 963) are configured to share one output terminal (846; 856; 966), and each of the plurality of filters (842; 843; 852; 853; 962; 963) are configured to connect the amplifier (849; 859; 969) through the one output terminal (846; 856; 966),
and wherein the second filter unit (871; 881; 971) comprises a second plurality of filters (872; 873; 882; 883; 972; 973) and a plurality of output terminals (876; 877; 886; 887; 976; 977), an output terminal being individually connected to each of the second plurality of filters, and each output terminal being individually connected to the wireless processor (530).

8. The method of claim 7, wherein the plurality of filters (842; 843; 852; 853; 962; 963) are configured to share one input terminal (844; 854; 964) and each of the plurality of filters (842; 843; 852; 853; 962; 963) are configured to receive the wireless signal through the one input terminal (844; 854; 964).

9. The method of claim 7, wherein each of the plurality of filters (832; 833; 862; 863) comprises different input terminals (834; 835; 864; 865) and each of the plurality of filters (832; 833; 862; 863) are configured to receive the wireless signal through the different input terminals (834; 835; 864; 865).

10. The method of claim 7,
wherein the second plurality of filters (872; 873; 882; 883; 972; 973) are configured to correspond to different frequency bands; and
wherein frequency bands of the additional filters are equal to frequency bands of filters (842; 843; 852; 853; 962; 963) included in a filtering module (840; 850; 960) which is coupled to the second filter unit (871; 881; 971).

11. The method of claim 10, wherein the second plurality of filters (872; 873; 882; 883; 972; 973) is configured to share one input terminal (874; 884; 974), and each of the additional filters (872; 873; 882; 883; 972; 973) configured to connect the amplifier (849; 859; 969) through the one input terminal (874; 884; 974).

12. The method of claim 7, further comprising:
processing the amplified signal by the wireless processor (530) (operation 1017); and
controlling the connection between the antenna and the at least one filtering module (840; 850; 960), by a switch (810) which is disposed between the antenna (510) and the at least one filtering module (840; 850; 960).

## Patentansprüche

1. Elektronische Vorrichtung (101), umfassend:
mindestens eine Antenne (510);
mindestens ein Filtermodul (840; 850; 960), das zum Filtern eines von der Antenne (510) empfangenen Funksignals gestaltet ist; und
einen Funkprozessor (530),
wobei das mindestens eine Filtermodul (840; 850; 960) folgendes umfasst:
eine erste Filtereinheit (841; 851; 961), die eine erste Mehrzahl von Filtern (842; 843; 852; 853; 962; 963) umfasst, die so gestaltet sind, dass sie verschiedene Frequenzbänder durchleiten, die nebeneinander liegen; und
einen Verstärker (849; 859; 969), der so gestaltet ist, dass er das Funksignal verstärkt, das durch die erste Filtereinheit (841; 851; 961) getreten ist,
wobei die elektronische Vorrichtung ferner eine zweite Filtereinheit (871; 881; 971) umfasst, die mit dem mindestens einen Filtermodul (840; 850; 960) verbunden ist, wobei die zweite Filtereinheit (871; 881; 971) so gestaltet ist, dass sie das verstärkte Funksignal von dem mindestens einen Filtermodul (840; 850; 960) empfängt und ein vorbestimmtes Frequenzband in dem empfangenen Funksignal durchleitet;
wobei die erste Mehrzahl von Filtern (842; 843; 852; 853; 962; 963) so gestaltet ist, dass sie einen Ausgangsanschluss (846; 856; 966) gemeinsam nutzen, und wobei jeder Filter der ersten Mehrzahl von Filtern (842; 843; 852; 853; 962; 963) für eine Verbindung mit dem Verstärker (839; 849; 859; 869) über den einen Ausgangsanschluss (846; 856; 966) gestaltet ist,
und wobei die zweite Filtereinheit (871; 881; 971) eine zweite Mehrzahl von Filtern (872; 873; 882; 883; 972; 973) und eine Mehrzahl von Ausgangsanschlüssen (876; 877; 886; 887; 976; 977) umfasst, wobei ein Ausgangsanschluss einzeln mit jedem Filter der zweiten Mehrzahl von Filtern (872; 873; 882; 883; 972; 973) verbunden ist, und wobei jeder Ausgangsanschluss einzeln mit dem Funkprozessor (530) verbunden ist.

2. Elektronische Vorrichtung nach Anspruch 1, wobei die erste Mehrzahl von Filtern (842; 843; 852; 853) so gestaltet ist, dass sie einen Eingangsanschluss (844; 854) gemeinsam nutzen, und wobei jeder Filter der ersten Mehrzahl von Filtern (842; 843; 852; 853) so gestaltet ist, dass er das Funksignal über den einen Eingangsanschluss (844; 854) empfängt.

3. Elektronische Vorrichtung nach Anspruch 1, wobei jeder Filter der ersten Mehrzahl von Filtern (832; 833; 862; 863) verschiedene Eingangsanschlüsse (834; 835; 864; 865) umfasst, wobei jeder der ersten Mehrzahl von Filtern (832; 833; 862; 863) so gestaltet ist, dass er das Funksignal über die verschiedenen Eingangsanschlüsse (834; 835; 864; 865) empfängt.

4. Elektronische Vorrichtung nach Anspruch 1,
wobei die zweite Mehrzahl von Filtern (872; 873; 882; 883; 972; 973) jeweils so gestaltet ist, dass sie verschiedenen Frequenzbändern entsprechen; und
wobei die Frequenzbänder der zweiten Mehrzahl von Filtern den Frequenzbändern der ersten Mehrzahl von Filtern (842; 843; 852; 853; 962; 963) entsprechen, die in dem Filtermodul (840; 850; 960) enthalten sind, das mit der zweiten Filtereinheit (871; 881; 971) gekoppelt ist.

5. Elektronische Vorrichtung nach Anspruch 4, wobei die zweite Mehrzahl von Filtern (872; 873; 882; 883; 972; 973) so gestaltet ist, dass sie einen Eingangsanschluss (874; 884; 974) gemeinsam nutzen, und wobei jeder Filter der zweiten Mehrzahl von Filtern (872; 873; 882; 883; 972; 973) für eine Verbindung mit dem Verstärker (849; 859; 969) über den einen Eingangsanschluss (874; 884; 974) gestaltet ist.

6. Elektronische Vorrichtung nach Anspruch 1, ferner umfassend:
einen Schalter (810), der so gestaltet ist, dass er die Verbindung zwischen der Antenne (510) und dem Filtermodul (840; 850; 860) steuert.

7. Verfahren einer elektronischen Vorrichtung (101) mit mindestens einer Antenne (510) und einem Funkprozessor (530), wobei das Verfahren folgendes umfasst:
Verbinden mindestens eines Filtermoduls (840; 850; 960) mit der Antenne (510) (Operation 1011);
durch eine erste Filtereinheit (841; 851; 961) des mindestens einen Filtermoduls (840; 850; 960), Filtern eines von der Antenne (510) empfangenen Funksignals (Operation 1013);
durch einen Verstärker (849; 859; 969), der mit der ersten Filtereinheit (841; 851; 961) verbunden ist, Verstärken des Funksignals, das durch die erste Filtereinheit (841; 851; 961) getreten ist (Operation (1015); und
durch eine zweite Filtereinheit (871; 881; 971), die mit dem Verstärker (839; 849; 859; 869) verbunden ist, Filtern des verstärkten Funksignals,
wobei das mindestens eine Filtermodul (840; 850; 960) folgendes umfasst:
die erste Filtereinheit (841; 851; 961), die eine Mehrzahl von Filtern (842; 843; 852; 853; 962; 963) umfasst, die so gestaltet sind, dass sie verschiedene Frequenzbänder durchleiten, die nebeneinander liegen; und
den Verstärker (849; 859; 969), der so gestaltet ist, dass er das Funksignal verstärkt, das durch die erste Filtereinheit (841; 851; 961) getreten ist,
wobei die Mehrzahl von Filtern (842; 843; 852; 853; 962; 963) so gestaltet ist, dass sie einen Ausgangsanschluss (846; 856; 966) gemeinsam nutzen, und wobei jeder Filter der Mehrzahl von Filtern (842; 843; 852; 853; 962; 963) für eine Verbindung mit dem Verstärker (849; 859; 869) über den einen Ausgangsanschluss (846; 856; 966) gestaltet ist,
und wobei die zweite Filtereinheit (871; 881; 971) eine zweite Mehrzahl von Filtern (872; 873; 882; 883; 972; 973) und eine Mehrzahl von Ausgangsanschlüssen (876; 877; 886; 887; 976; 977) umfasst, wobei ein Ausgangsanschluss einzeln mit jedem Filter der zweiten Mehrzahl von Filtern verbunden ist, und wobei jeder Ausgangsanschluss einzeln mit dem Funkprozessor (530) verbunden ist.

8. Verfahren nach Anspruch 7, wobei die Mehrzahl von Filtern (842; 843; 852; 853; 962; 963) so gestaltet ist, dass sie einen Eingangsanschluss (844; 854; 964) gemeinsam nutzen, und wobei jeder Filter der Mehrzahl von Filtern (842; 843; 852; 853; 962; 963) so gestaltet ist, dass er das Funksignal über den einen Eingangsanschluss (844; 854; 964) empfängt.

9. Verfahren nach Anspruch 7, wobei jeder Filter der Mehrzahl von Filtern (832; 833; 862; 863) verschiedene Eingangsanschlüsse (834; 835; 864; 865) umfasst, und wobei jeder Filter der Mehrzahl von Filtern (832; 833; 862; 863) so gestaltet ist, dass er das Funksignal über die verschiedenen Eingangsanschlüsse (834; 835; 864; 865) empfängt.

10. Verfahren nach Anspruch 7, wobei die zweite Mehrzahl von Filtern (872; 873; 882; 883; 972; 973) so gestaltet ist, dass sie verschiedenen Frequenzbändern entsprechen; und
wobei die Frequenzbänder der zusätzlichen Filter den Frequenzbändern der Filter (842; 843; 852; 853; 962; 963) entsprechen, die in einem Filtermodul (840; 850; 960) enthalten sind, das mit der zweiten Filtereinheit (871; 881; 971) gekoppelt ist.

11. Verfahren nach Anspruch 10, wobei die zweite Mehrzahl von Filtern (872; 873; 882; 883; 972; 973) so gestaltet ist, dass sie einen Eingangsanschluss (874; 884; 974) gemeinsam nutzen, und wobei jeder der zusätzlichen Filter (872; 873; 882; 883; 972; 973) gestaltet ist für eine Verbindung mit dem Verstärker (849; 859; 969) über den einen Eingangsanschluss (874; 884; 974).

12. Verfahren nach Anspruch 7, ferner umfassend:
Verarbeiten des verstärkten Signals durch den Funkprozessor (530) (Operation 1017); und
Steuern der Verbindung zwischen der Antenne und dem mindestens einen Filtermodul (840; 850; 960) durch einen Schalter (810), der sich zwischen der Antenne (510) und dem mindestens einen Filtermodul (840; 850; 960) befindet.

## Revendications

1. Dispositif électronique (101) comprenant :
au moins une antenne (510) ;
au moins un module de filtrage (840 ; 850 ; 960) conçu pour filtrer un signal sans fil reçu de l'antenne (510) ; et
un processeur sans fil (530),
l'au moins un module de filtrage (840 ; 850 ; 960) comprenant :
une première unité de filtrage (841 ; 851 ; 961) comprenant une première pluralité de filtres (842 ; 843 ; 852 ; 853 ; 962 ; 963) conçus pour passer différentes bandes de fréquences qui sont adjacentes les unes aux autres ; et
un amplificateur (849 ; 859 ; 969) conçu pour amplifier le signal sans fil qui a traversé la première unité de filtrage (841 ; 851 ; 961),
le dispositif électronique comprenant en outre une seconde unité de filtrage (871 ; 881 ; 971) qui est connectée à l'au moins un module de filtrage (840 ; 850 ; 960), la seconde unité de filtrage (871 ; 881 ; 971) étant conçue pour recevoir le signal sans fil amplifié de l'au moins un module de filtrage (840 ; 850 ; 960) et passer une bande de fréquence prédéfinie dans le signal sans fil reçu,
la première pluralité de filtres (842 ; 843 ; 852 ; 853 ; 962 ; 963) étant conçue pour partager une borne de sortie (846 ; 856 ; 966), et chaque filtre de la première pluralité de filtres (842 ; 843 ; 852 ; 853 ; 962 ; 963) étant conçu pour connecter l'amplificateur (839 ; 849 ; 859 ; 869) par l'intermédiaire de la borne de sortie (846 ; 856 ; 966),
et la seconde unité de filtrage (871 ; 881 ; 971) comprenant une seconde pluralité de filtres (872 ; 873 ; 882 ; 883 ; 972 ; 973) et une pluralité de bornes de sortie (876 ; 877 ; 886 ; 887 ; 976 ; 977), une borne de sortie étant connectée individuellement à chaque filtre de la seconde pluralité de filtres (872, 873, 882, 883 ; 972, 973), et chaque borne de sortie étant connectée individuellement au processeur sans fil (530).

2. Dispositif électronique selon la revendication 1, la première pluralité de filtres (842 ; 843 ; 852 ; 853) étant conçue pour partager une borne d'entrée (844 ; 854) et chaque filtre de la première pluralité de filtres (842 ; 843 ; 852 ; 853) étant conçu pour recevoir le signal sans fil par l'intermédiaire de la borne d'entrée (844 ; 854).

3. Dispositif électronique selon la revendication 1, chaque filtre de la première pluralité de filtres (832 ; 833 ; 862 ; 863) comprenant différentes bornes d'entrée (834 ; 835 ; 864 ; 865), chaque filtre de la première pluralité de filtres (832 ; 833 ; 862 ; 863) étant conçu pour recevoir le signal radio par l'intermédiaire des différentes bornes d'entrée (834 ; 835 ; 864 ; 865).

4. Dispositif électronique selon la revendication 1,
chaque filtre de la seconde pluralité de filtres (872 ; 873 ; 882 ; 883 ; 972 ; 973) étant conçu pour correspondre à des bandes de fréquences différentes ; et
les bandes de fréquences de la seconde pluralité de filtres étant égales aux bandes de fréquences de la première pluralité de filtres (842 ; 843 ; 852 ; 853 ; 962 ; 963) incluse dans le module de filtrage (840 ; 850 ; 960) qui est couplé à la seconde unité de filtre (871 ; 881 ; 971).

5. Dispositif électronique selon la revendication 4, la seconde pluralité de filtres (872 ; 873 ; 882 ; 883 ; 972 ; 973) étant conçue pour partager une borne d'entrée (874 ; 884 ; 974), et chaque filtre de la seconde pluralité de filtres (872 ; 873 ; 882 ; 883 ; 972 ; 973) étant conçu pour connecter l'amplificateur (849 ; 859 ; 969) par l'intermédiaire de la borne d'entrée (874 ; 884 ; 974).

6. Dispositif électronique selon la revendication 1, comprenant en outre :
un commutateur (810) conçu pour commander la connexion entre l'antenne (510) et le module de filtrage (840 ; 850 ; 960).

7. Procédé d'un dispositif électronique (101) ayant au moins une antenne (510) et un processeur sans fil (530), le procédé comprenant les étapes :
connexion d'au moins un module de filtrage (840 ; 850 ; 960) à l'antenne (510) (opération 1011) ;
filtrage, par une première unité de filtrage (841 ; 851 ; 961) de l'au moins un module de filtrage (840 ; 850 ; 960), d'un signal sans fil reçu de l'antenne (510) (opération 1013) ;
amplification, par un amplificateur (849 ; 859 ; 969) connecté à la première unité de filtrage (841 ; 851 ; 961), du signal sans fil qui a traversé la première unité de filtrage (841 ; 851 ; 961) (opération 1015) ; et
filtrage, par une seconde unité de filtrage (871 ; 881 ; 971) connectée à l'amplificateur (839 ; 849 ; 859 ; 869), du signal sans fil amplifié,
l'au moins un module de filtrage (840 ; 850 ; 960) comprenant :
la première unité de filtrage (841 ; 851 ; 961) comprenant une pluralité de filtres (842 ; 843 ; 852 ; 853 ; 962 ; 963) conçue pour passer différentes bandes de fréquences qui sont adjacentes les unes aux autres ; et
l'amplificateur (849 ; 859 ; 969) conçu pour amplifier le signal sans fil qui a traversé la première unité de filtrage (841 ; 851 ; 961),
la pluralité de filtres (842 ; 843 ; 852 ; 853 ; 962 ; 963) étant conçue pour partager une borne de sortie (846 ; 856 ; 966), et chaque filtre de la pluralité de filtres (842 ; 843 ; 852 ; 853 ; 962 ; 963) étant conçu pour connecter l'amplificateur (849 ; 859 ; 969) par l'intermédiaire de la borne de sortie (846 ; 856 ; 966),
et la seconde unité de filtrage (871 ; 881 ; 971) comprenant une seconde pluralité de filtres (872 ; 873 ; 882 ; 883 ; 972 ; 973) et une pluralité de bornes de sortie (876 ; 877 ; 886 ; 887 ; 976 ; 977), une borne de sortie étant connectée individuellement à chaque filtre de la seconde pluralité de filtres, et chaque borne de sortie étant connectée individuellement au processeur sans fil (530).

8. Procédé selon la revendication 7, la pluralité de filtres (842 ; 843 ; 852 ; 853 ; 962 ; 963) étant conçue pour partager une borne d'entrée (844 ; 854 ; 964) et chaque filtre de la pluralité de filtres (842 ; 843 ; 852 ; 853 ; 962 ; 963) étant conçu pour recevoir le signal radio par l'intermédiaire de la borne d'entrée (844 ; 854 ; 964).

9. Dispositif électronique selon la revendication 7, chaque filtre de la première pluralité de filtres (832 ; 833 ; 862 ; 863) comprenant différentes bornes d'entrée (834 ; 835 ; 864 ; 865) et chaque filtre de la première pluralité de filtres (832 ; 833 ; 862 ; 863) étant conçu pour recevoir le signal radio par l'intermédiaire des différentes bornes d'entrée (834 ; 835 ; 864 ; 865).

10. Procédé selon la revendication 7,
la seconde pluralité de filtres (872 ; 873 ; 882 ; 883 ; 972 ; 973) étant conçue pour correspondre à des bandes de fréquences différentes ; et
les bandes de fréquences des filtres supplémentaires étant égales aux bandes de fréquences de filtres (842 ; 843 ; 852 ; 853 ; 962 ; 963) inclus dans un module de filtrage (840 ; 850 ; 960) qui est couplé à la seconde unité de filtre (871 ; 881 ; 971).

11. Procédé selon la revendication 10, la seconde pluralité de filtres (872 ; 873 ; 882 ; 883 ; 972 ; 973) étant conçue pour partager une borne d'entrée (874 ; 884 ; 974), et chacun des filtres supplémentaires (872 ; 873 ; 882 ; 883 ; 972 ; 973) étant conçu pour connecter l'amplificateur (849 ; 859 ; 969) par l'intermédiaire de la borne d'entrée (874 ; 884 ; 974).

12. Procédé selon la revendication 7, comprenant en outre les étapes :
traitement du signal amplifié par le processeur sans fil (530) (opération 1017) ; et
commande de la connexion entre l'antenne et l'au moins un module de filtrage (840 ; 850 ; 960), par un commutateur (810) qui est disposé entre l'antenne (510) et l'au moins un module de filtrage (840 ; 850 ; 960).
